# EUROPEAN PATENT SPECIFICATION

(11) **EP 2 066 721 B1**
(45) Date of publication and mention of the grant of the patent: **27.12.2017**
(21) Application number: 07820312.2
(22) Date of filing: 19.09.2007
(51) Int. Cl.: C08G 18/80, C08K 5/3442, C08K 5/3462

(54) **PHOTOLATENT BASES FOR SYSTEMS BASED ON BLOCKED ISOCYANATES**
FOTOLATENTE BASEN FÜR SYSTEME AUF DER BASIS VON BLOCKIERTEN ISOCYANATEN
BASES PHOTOLATENTES POUR SYSTEMES FONDES SUR DES ISOCYANATES BLOQUÉS

(30) Priority: 29.09.2006 EP 06121469
(43) Date of publication of application: 10.06.2009
(73) Proprietor: BASF SE, 67056 Ludwigshafen am Rhein (DE)
(72) Inventor: STUDER, Katia, 68170 Rixheim (FR); DIETLIKER, Kurt, 4123 Allschwil (CH); JUNG, Tunja, 79618 Rheinfelden-Herten (DE)
(74) Representative: Maiwald Patentanwalts GmbH
(86) International application number: PCT/EP2007/059865
(87) International publication number: WO 2008/037635

(56) References cited:
- WO-A-98/41524
- WO-A1-03/033500

## Description

The invention pertains to process for crosslinking a blocked isocyanate and and a H-donor by admixing said components with a photolatent base catalyst.

Compositions comprising blocked isocyanate compounds, a hydrogen donor compound and a catalyst are known in the art, e.g. from WO 95/04093. The compositions usually are crosslinked via a thermal process, for example employing thermal latent catalyst.

Coating and adhesive systems based on isocyanate/hydrogen donor, e.g. polyol, formulations show a poor stability, gelation occuring within a few hours at room temperature. Uncatalyzed systems based on blocked isocyanates and hydrogen donors provide stable formulations at low temperature. In said systems by action of heat and/or a catalyst the isocyanate is deblocked or alternatively the blocking group is reacted in a way to provide a crosslink. Thus allowing the addition of the hydrogen donor compound to the isocyanate component before, during or after the heating step. Hence, stable systems lead to the formation of crosslinks at high temperature, usually between 120°C and 140°C. Catalysts help to decrease the bake temperature of such systems, sometimes adversely affecting the stability of the formulation.
To provide stable formulations while simultaneously reducing the bake temperature would be recognized in the art.
It has now been found that the addition of certain photolatent catalysts provides stable formulations while reducing the bake temperature of blocked isocyanate/hydrogen donor mixtures after light activation of the catalyst.

WO 98/41524 relates to organic compounds having a molecular weight of less than 1000 comprising at least one special structural unit containing a defined aromatic or heteroaromatic radical, wherein the compound is capable of absorbing light in the wavelength range from 200 to 650 nm and in doing so brings about cleavech of an adjacent carbon-nitrogen bond.

The present specification describes a composition comprising
(a) a photolatent base;
(b) a blocked isocyanate or blocked isothiocyanate and
(c) a hydrogen donor compound.

Surprisingly said compositions have improved stability while simultaneously showing a similar reactivity after light activation than with the non-latent catalyst. The stable formulations based on blocked isocyanates exhibit a fast curing after light-exposure.

In the present invention a photolatent base (a) is used as the catalyst for crosslinking blocked isocyanate components (b) with a hydrogen donor component (c).

The preparation of photolatent base compounds is known and is for example described in WO 98/32756, WO 98/41524 and WO 03/33500. Those specifications also provide specific examples of such compounds.
Also suitable as photolatent base donors are the α-aminoketone compounds described in EP 898 202, for example (4-morpholinobenzoyl)-1-benzyl-1-dimethylamino-propane or (4-methylthiobenzoyl)-1-methyl-1-morpholino-ethane and compounds as disclosed in WO 05/007637.
Preparation and use of photolatent bases of the formula Z3-A3 is for example disclosed in WO 97/31033.
A summary of further photobase generators is given in the form of a review by M. Shirai and M. Tsunooka in Prog. Polym. Sci., Vol. 21, 1-45 (1996). and in J. Crivello, K. Dietliker, "Photoinititiators for Free Radical Cationic & Anionic Photopolymerisation", 2nd Edition, Volume III in the Series "Chemistry & Technology of UV & EB Formulation for Coatings, Inks & Paints", John Wiley/SITA Technology Limited, London, 1998, Chapter IVI (p. 479-544).

In particular interesting compositions are such wherein
the photolatent base is of the formula (I) 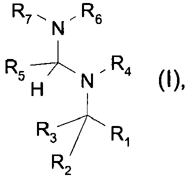 wherein
**R₁** is an aromatic or heteroaromatic radical which is capable of absorbing light in the wavelength range from 200 to 650 nm and which is unsubstituted or substituted by one ore more C₁-C₁₈-alkyl, C₂-C₁₈-alkenyl, C₂-C₁₈-alkyinyl, C₁-C₁₈-haloalkyl, NR₈R₉, CN, OR₁₀, SR₁₀, COR₁₁, COOR₁₂, halogen or 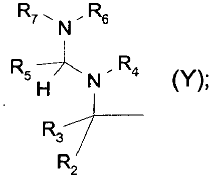
or **R₁** is 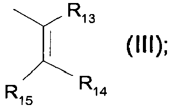
**R₂** and **R₃** independently of each other are hydrogen, C₁-C₁₈-alkyl, C₁-C₁₈-alkenyl, C₃-C₁₈-alkinyl or phenyl which is unsubstituted or substituted by one or more C₁-C₁₈-alkyl, CN, OR₁₂, SR₁₂, halogen, or C₁-C₁₈-haloalkyl;
**R₅** is C₁-C₁₈-alkyl or NR₁₀R₁₁;
**R₄, R₆, R₇, R₈** and **R₉** independently of one another are hydrogen or C₁-C₁₈-alkyl; or
**R₄** and **R₆** together form a C₂-C₁₂-alkylene bridge which is unsubstituted or substituted by one ore more C₁-C₄-alkyl; or
**R₅** and **R₇,** independently of R₄ and R₆, together form a C₂-C₁₂alkylene bridge which is unsubstituted or substituted by one ore more C₁-C₄-alkyl or, if R₅ is NR₁₀R₁₁, R₇ and R₁₁ together form a C₂-C₁₂-alkylene bridge which is unsubstituted or substituted by one ore more C₁-C₄-alkyl;
**R₁₀, R₁₁** and **R₁₂** independently of each other are hydrogen or C₁-C₁₈alkyl;
**R₁₃** is an aromatic or heteroaromatic radical which is capable of absorbing light in the wavelength range from 200 to 650 nm and which is unsubstituted or substituted by one ore more of the substituents C₁-C₁₈-alkyl, C₂-C₁₈-alkenyl, C₂-C₁₈-alkinyl, C₁-C₁₈-haloalkyl, NR₈R₉, CN, OR₁₀, SR₁₀, COR₁₁, COOR₁₂, or halogen;
**R₁₄** is hydrogen or C₁-C₁₈-alkyl;
**R₁₅** is hydrogen, C₁-C₁₈-alkyl or phenyl which is unsubstituted or substituted by one or more C₁-C₁₈-alkyl, vinyl, C₃-C₁₈-alkenyl, C₃-C₁₈-alkinyl, C₁-C₁₈-haloalkyl, phenyl, NR₈R₉, CN, OR₁₀, SR₁₀, COR₁₁, COOR₁₂ or halogen.

Preferred are compositions as described above as photolatent base (a) comprising a compound of the formula (I) 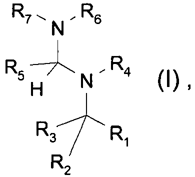 wherein
**R₁** is phenyl, biphenylyl, naphthyl, anthryl or anthraquinonyl all of which are unsubstituted or substituted by one ore more C₁-C₄-alkyl, C₂-C₄-alkenyl, CN, OR₁₀, SR₁₀, COOR₁₂, halogen or 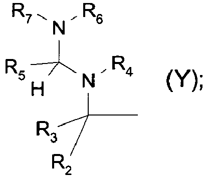
or **R₁** is 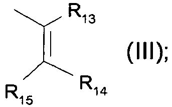
**R₂** and **R₃** independently of each other are hydrogen or C₁-C₆-alkyl;
**R₄** and **R₆** together form a C₂-C₆-alkylene bridge which is unsubstituted or substituted by one ore more C₁-C₄-alkyl;
**R₈** and **R₇** together form a C₂-C₆-alkylene bridge which is unsubstituted or substituted by one ore more C₁-C₄-alkyl;
**R₁₀, R₁₁** and **R₁₂** independently of each other are hydrogen or C₁-C₆-alkyl;
**R₁₃** is is phenyl, biphenylyl, naphthyl, anthryl or anthraquinonyl all of which are unsubstituted or substituted by one ore more C₁-C₄-alkyl, C₂-C₄-alkenyl, CN, OR₁₀, SR₁₀, COOR₁₂, or halogen;
**R₁₄** is hydrogen; and
**R₁₅** is hydrogen or C₁-C₄-alkyl.

**C₁-C₁₈alkyl** is linear or branched and is, for example,C₁-C₁₈-, C₁-C₁₄-, C₁-C₁₂-, C₁-C₈-, C₁-C₆- or C₁-C₄alkyl. Examples are methyl, ethyl, propyl, isopropyl, n-butyl, sec-butyl, isobutyl, tert-butyl, pentyl, hexyl, heptyl, 2,4,4-trimethylpentyl, 2-ethylhexyl, octyl, nonyl, decyl, dodecyl, tetradecyl, pentadecyl, hexadecyl, octadecyl and icosyl.
C₁-C₁₄alkyl, C₁-C₁₂alkyl, C₁-C₈alkyl, C₁-C₆alkyl and C₁-C₄alkyl have the same meanings as given above for C₁-C₂₀alkyl up to the corresponding number of C-atoms.

**C₁-C₁₈Haloalkyl** is linear or branched C₁-C₁₈-, C₁-C₁₄-, C₁-C₁₂-, C₁-C₁₀-, C₁-C₈-, C₁-C₆- or C₁-C₄-alkyl mono- or poly-substituted by halogen, the alkyl being, for example, as defined above. The alkyl radical is for example mono- or poly-halogenated, up to the exchange of all H-atoms by halogen. C₁-C₂₀alkyl substituted by one or more halogen is for example Cₙ[HₓHal_{y}]₂ₙ₊₁, wherein the sum of x+y = 2n+1 and Hal, is halogen, preferably F. Examples are chloromethyl, trichloromethyl, trifluoromethyl or 2-bromopropyl, especially trifluoromethyl or trichloromethyl. **C₂-C₁₈-alkenyl** is for example mono or polyunsaturated, linear or branched and is for example C₂-C₁₈-, C₂-C₁₀-, C₂-C₈-, C₂-C₆- or C₂-C₄alkenyl. Examples are allyl, methallyl, vinyl, 1,1-dimethylallyl, 1-butenyl, 3-butenyl, 2-butenyl, 1,3-pentadienyl, 5-hexenyl or 7-octenyl, especially allyl or vinyl.
**C₂-C₁₈-alkinyl** is mono or polyunsaturated, linear or branched and is for example C₂-C₈-, C₂-C₆- or C₂-C₄alkinyl. Examples are ethinyl, propinyl, butinyl, 1-butinyl, 3-butinyl, 2-butinyl, pentinyl hexinyl, 2-hexinyl, 5-hexinyl, octinyl, etc.
C₁-C₁₂alkylene is linear or branched for example C₁-C₁₂-, C₁-C₁₀-, C₁-C₈-, C₁-C₆-, C₁-C₄alkylene, for example methylene, ethylene, propylene, 1-methylethylene 1,1-dimethylethylene, butylene, 1-methylpropylene, 2-methyl-propylene, pentylene, hexylene, heptylene, octylene, nonylene, decylene, or dodecylene.
**C₂-C₁₂alkylene** which is interrupted one or more times by O or S is linear or branched and is for example interrupted 1-9 times, for example 1-7 times or once or twice by O or S. This produces for exsample structural units such as, for example, CH₂-O-CH₂, CH₂-S-CH₂, CH₂CH₂-O-CH₂CH₂, etc.. The interrupting atoms are non-successive.

**Halogen** is fluorine, chlorine, bromine and iodine, especially fluorine, chlorine and bromine, preferably fluorine and chlorine.
**C₂-C₁₈-alkenyl** is for example mono or polyunsaturated, linear or branched and is for example C₂-C₁₈-, C₂-C₁₀-, C₂-C₈-, C₂-C₆- or C₂-C₄alkenyl. Examples are allyl, methallyl, vinyl, 1,1-dimethylallyl, 1-butenyl, 3-butenyl, 2-butenyl, 1,3-pentadienyl, 5-hexenyl or 7-octenyl, especially allyl or vinyl.

Substituted phenyl, biphenylyl, naphthyl, anthryl or anthraquinonyl are for example substituted one to four times, for example one, two or three times, especially two or three times. Substituents on the phenyl ring are preferably in positions 2 or in 2,6 or 2,4,6 configuration on the phenyl ring.
Naphthyl denotes 1-naphthyl and 2-naphthyl.

The term "and/or" is intended to express the fact that not just one of the alternatives defined (substituents) may be present but that it is likewise possible for there to be two or more different alternatives (substituents) from among those defined, together, i.e. mixtures of different alternatives (substituents).
The term "at least" is intended to define one or more than one, e.g. one or two or three, preferably one or two.
In the description and the claims, the word "comprising" is to be understood to mean that a defined subject or a defined group of subjects is included but without ruling out any other substances not explicitly mentioned, unless expressly described otherwise.

Accordingly interesting are compounds of the formula (Ia), 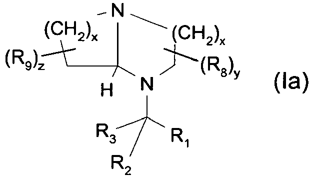 wherein
**x** is an integer from 1-5;
**y** and **z** independently of each other are an integer from 0-6;
**R₈** and **R₉** independently of each other are C₁-C₄alkyl;
**R₁, R₂** and **R₃** are as defined above.

If in the above compounds of the formula Ia more than one R₂₀ or R₂₁ is present, the definitions of said radicals have not to be similar. In other words: one R₂₀ may represent C₁alkyl, while another R₂₀ may be C₄alkyl, etc.

Of special interest therefore are compositions as described above, wherein the compounds of formula I

Emphasis has to be laid on compounds of the formula (lb), (Ic) and (Id), 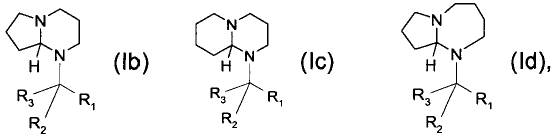 wherein
**R₁, R₂** and **R₃** are as defined above.

In particular interesting are compounds of the formula (lb).

Interesting further are compounds of the formula (le) 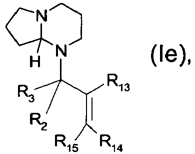 wherein
**R₂, R₃, R₁₃, R₁₄** and **R₁₅** are as defined above.

In particular preferred are 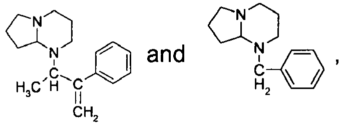 especially

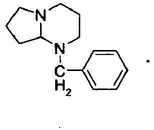

Examples of further photolatent bases are (4-morpholinobenzoyl)-1-benzyl-1-dimethylamino-propane, (4-methylthiobenzoyl)-1-methyl-1-morpholino-ethane, (3,4-dimethoxybenzoyl)-1-methyl-1-morpholino-ethane, (4-morpholinobenzoyl)-1-(4-methylbenzyl)-1-dimethylamino-propane, (4-(2-hydroxyethylamino)benzoyl)-1-benzyl-1-dimethylamino-propane, 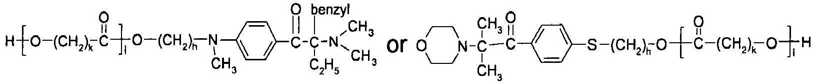 wherein I is an integer from about 1-10, k is an integer from about 2 to 10, in particular 5, h is an integer from 1 to 10, in particular 2 or

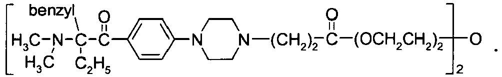

An embodiment of the invention pertains to the use of a compound of the formula I as defined above as photolatent base catalyst (a) for the curing of compositions comprising (b) a blocked isocyanate and a H-donor (c).

Blocked isocyanates are known in the art and for example described in a review article by D.A. Wicks, Z.W. Wicks in Progress in Organic Coatings, 41 (2001), 1-83*,* as well as by C. Gürtler, M. Homann, M. Mager, M. Schelhaas, T. Stingl, Farbe+Lack 2004, 110(12), 34*;* both documents incorporated herein by reference.

The terms "isocyanate" and isothiocyanates are used herein to refer to mono- and polyisocyanates and to mono- and polyisothiocyanates.
In general the term covers any compound containing one or more -N=C=Y groups in which Y is oxygen or sulfur. Examples of polyisocyanates suitable for the present invention include aliphatic compounds such as trimethylene, tetramethylene, pentamethylene, hexamethylene, 1,2-proplylene, 1,2-butylene, 2,3-butylene, 1,3-butylene, ethylidine and butylidene diisocyanates. Additionally, the cycloalkylene diisocyanates can be employed such as 1,3-cyclopentane, 1,4-cyclohexane, and 1 2-cyclohexane diisocyanates. Aromatic diisocyanates are also suitable, such as m-phenylene, p-phenylene, 4,4'-diphenyl, 1,5-naphthalene and 1,4-napthalene diisocyanates as well as the aliphatic-aromatic diisocyanates such as 4,4'-diphenylene methane, 2,4- or 2,6-tolylene or mixtures thereof, 4,4'-toluidine, and 1,4-xylylene diisocyanates. Substituted aryl or aromatic diisocyanates may also be employed such as dianisidine diisocyanate, 4,4'-diphenylether diisocyanate and chlorodiphenylene diisocyanate, 1,8-diisocyanato- -menthane, 1-methyl-2,4-diisocyanatocyclohexane, chlorophenylene diisocyanates, diphenyl-methane-4,4'-diisocyanate and naphthalene-1,5-diisocyanate. Additionally, the triisocyanates such as triphenyl methane-4,4',4"-triisocyanate, 1,3,5-triisocyanate benzene and 2,4,6-triisocyanate toluene may also be employed. Further tetra-isocyanates may be utilized such as for example 4,4'-diphenol-dimethyl methane-2,2',5,5'-tetraisocyanate as well as other isocyanates such as xylylene-diisothiocyanate, isopropylbenzene-diisocyanate and polymerized polyisocyanates such as tolulene diisocyanate dimers and trimers; dianisidine diisocyanate (CAS Registry No. 91-93-0); toluidine diisocyanate (CAS Registry No. 91-97-4); biuret of hexamethylene diisocyanate (CAS Registry No. 4035-89-6); isophorone diisocyanate (CAS Registry No. 4098-71-9); polymeric diphenol ethane diisocyanate (CAS Registry No. 9016-87-9) or 4,4'-dicyclohexylmethane diisocyanate. Various mixtures of isocyanates may also be used especially two, three, or four component mixtures.
The organic polyisocyanates may also be a prepolymer derived from a polyol and a polyisocyanate so that the polyol contains an isocyanate group or groups where the polyols include polyether polyols or polyester polyols or simple polyols such as glycols, including ethylene glycol and propylene glycol as well as glycerol, trimethylolpropane, hexanetriol, pentaerythritol, and the like.
The above summary of suitable isocynate components is not to be understood as limiting for the present invention, but only as list of illustrative examples.

As noted herein, the isocyanate of the component (b) of the present invention comprises a blocked isocyanate which is to say that the reactive isocyanate groups are reacted with any suitable blocking agent.

Examples of component (b) also are bis(cyclic ureas). These are blocked aliphatic diisocyanates and are preferred in some embodiments because no byproducts are formed upon release of the reactive isocyanate groups. These compounds can be referred to as self blocked isocyanates. Examples of these bis-cyclic ureas are described by Ulrich, ACS Svmm. Ser. 172 519 (1981, Sherwood, J. Coat. Technol. 54 (689), 61 (1982) and Kirk-Othmer Encyclopedia of Chemical Technology, Third Edition, Volume 23, p. 584 all of which are incorporated herein by reference.

In particular interesting as components (b) are compounds selected from the group consisting of aliphatic or aromatic polyisocyanates, diisocyanates, triisocyanates and tetraisocyanates.

Suitable blocking agents for the isocyanates are the ones known in the art, for example alcohols, phenols, amines, imides, amides, guanidines, amidines, triazoles, pyrazoles, active methylene compounds, ketoximes, oximes, malonesters, alkylacetoacetates, formiates, lactams, imidazoles, triazoles, pyrazoles, CH-acidic cyclic ketones and mercaptans.

Examples are aliphatic, cycloaliphatic, aromatic, or alkyl monoalcohol or phenolic compounds such as, for example, lower aliphatic alcohols including methyl, ethyl, chloroethyl, propyl, butyl, amyl, hexyl, heptyl, octyl, nonyl, decyl and lauryl alcohols, 3,3,5-trimethylhexanol and the like. The aromatic-alkyl alcohols include for example phenylcarbinol and ethylphenylcarbinol. Glycol ethers may be employed such as ethyl glycol monoethyl ether, ethyl glycol monobutyl ether and equivalents thereof. Examples of phenolic compounds which may be employed comprise phenol, substituted phenols such as cresol, xylenol, nitrophenol, chlorophenol, ethyl phenol, t-butyl phenol and 2,5-di-t-butyl-4-hydroxy toluene.
Examples of other blocking agents that may be employed include tertiary hydroxyl amines such as diethylethanolamin, lactams such as caprolactam and oximes such as methyl ethyl ketone oxime, acetone oxime and cyclohexanone oxime.

Specific examples are butanonoxime, diisoproylamine, 1,2,4-triazole, dimethyl-1,2,4-triazole, imidazole, ethylates of malonic and acetic acid, acetoneoxime, 3,5-dimethylpyrazole, epsilon-caprolactame, N-methyl-, N-ethyl, N-(iso)propyl, N-n-butyl, N-iso-butyl-, N-tert.-butylbenzylamine or, 1,1-dimethylbenzylamine, N-alkyl-N-1,1-dimethylmethylphenylamine; adducts of benzylamine and compounds with activated bouble bonds, such as malonic acid esters, N,N-dimethylaminopropylbenzylamine and other compounds comprising tertiary amine groups, where appropriate substituted benylamines and/or dibenzylamine.

Use of the oximes and phenols in some instances is desirable because some specific polyisocyanates blocked with these oximes or phenols uncap at relatively low temperatures.

Examples of suitable CH-acidic ketones are given in WO 04/058849 and incorporated herein by reference. Preferred are cyclopentanon-2-carboxymethylester, cyclopentanon-2-carboxyethylester, cyclopentanon-2-carboxynitrile, cyclohexanon-2-carboxymethylester, cyclohexanon-2-carboxyethylester, cyclopentanon-2-carbonylmethane, especially cyclopentanon-2-carboxymethylester, cyclopentanon-2-carboxyethylester, cyclohexanon-2-carboxymethylester and cyclohexanon-2-carboxyethylester, in particular cyclopentanon-2-carboxyethylester and cyclohexanon-2-carboxyethylester.
Accordingly the present specification describes a composition as described above, wherein the blocking agent is cyclopentanon-2-carboxymethylester, cyclopentanon-2-carboxyethylester, cyclopentanon-2-carboxynitrile, cyclohexanon-2-carboxymethylester, cyclohexanon-2-carboxyethylester, cyclopentanon-2-carbonylmethane.

It is evident that also mixtures of different blocking agents may be used and a blocked isocyanate wich may be employed in the presently claimed composition may have different blocking groups.
Specific examples of compounds that can function as blocking agents are disclosed in US 4256621 and US 4865704, both of which patents are expressly incorporated in their entirety herein by reference.

The present specification describes a composition wherein the blocking agent of the isocyanate is selected from the group consisting of alcohols, phenols, amines, imides, amides, guanidines, amidines, triazoles, pyrazoles, active methylene compounds, ketoximes, oximes, formiates, lactams, imidazoles, CH-acidic cyclic ketones, preferably cyclopentanon-2-carboxyethylester, and mercaptans.
In particular preferred blocking agents are CH-acidic ketones.
Interesting blocking agents are alcohols, phenols, amines, imides, amides, guanidines, amidines, triazoles, pyrazoles, active methylene compounds, ketoximes, oximes, formiates, lactams, imidazoles and mercaptans.

The blocked reactive isocyanate or isothiocyanate is reacted with a functional compound or functional component *containing* a reactive hydrogen as determined by the Zerewitinoff method described in J.Am.Chem.Soc., Vol. 49, p. 3181 (1927). These compounds or components containing reactive hydrogen atoms comprise compounds used for manufacturing a polyisocyanate prepolymer as previously described, e.g. polyols including polyether polyols or polyester polyols which is to say compounds containing hydroxyl groups. Additionally, compounds containing amino groups are also included within those materials that are functional components containing reactive hydrogen. Again, generally all compounds which give a positive test for reactive hydrogen as determined by the Zerewitinoff method are suitable.
These compounds or components include but are no limited to alcohols, phenols, boronic acids, carboxylic acids, percarboxylic acids and sulfonic acids and the like. Also included within this group are compounds containing a nitrogen-hydrogen bond such as amines, amides, lactams, ureas, urethanes, allophanates, biurets, acyl ureas, thioureas, hydrazones, oximes, amidines, hydroxylamines, hydrazones, hydroxamic acids, nitramines, diazoamino compounds and sulfonamides.
Compounds containing a sulfur-hydrogen bond are also included such as mercaptans, thiophenols and thioacids. Other compounds which are included are halogen acids, compounds containing active methylene groups and compounds capable of forming enols such as acetone, malonic esters, acetoacetic esters, acetylacetone and nitromethane and miscellaneous active hydrogen-containing compounds such as acetylenic compounds and dialkyl phosphonates.
Compounds containing two or more or any one or combination of active hydrogen groups already described are also included.

Suitable components (c) further are polyetherpolyols, for example with a molecular weight from 300 to 20000, especially from 1000 to 12000, preferably from 2000 to 6000.

Said higher molecular polyetherpolyols are generally known from conventional polyurethane chemistry and are prepared by known methods by alkoxylation of suitable starter molecules. Examples of starter molecules are usual polyols such as ethylenglycol, 1,2- or 1,3-propylenglycol, 1,4-butandiol, 1,6-hexandiol, neopentylglycol, 2-ethylhexandiol-1,3, glycerine, trimethylolpropane, pentaerythrite, sorbit, as well as low molecular weight esters of such polyols with aliphatic or aromatic dicarboxylic acids comprising hydroxyl groups. Further examples are low molecular products of ethoxylation and propoxylation reactions of such polyols or any mixtures of such modified or non-modified alcohols, water, organic polyamines with at least two N-H-bonds or any mixtures of such starter molecules.
Suitable for the alkoxylation are cyclic ethers such as tetrahydrofuran (THF) and/or alkylenoxides such as ethylenoxide, propylenoxide, butylenoxide, styreneoxide or epichlorohydrin, in particular ethylenoxide and/or propylenoxide, which are employed in any mixture or sequence for the alkoxylation reaction.

Other components (c) of interest are amines, e.g. polyamines with at least two primary amin groups per molecule and optionally additionally having secondary amino groups. Said polyamines for example have an average molecular weight from 60 to 500. Suitable are for example ethylenediamine, 1,2- and 1,3-diaminopropane, 1,4-diaminobutane, 2,2,4- and/or 2,4,4-trimethylhexamethylene-diamine, the isomeric xylolendiamines, 1,4-diaminocyclohexane, 4,4'-diaminodicyclohexylmethane, 1,3-diaminocyclopentane, 4,4'-diaminodicyclohexyl-sulfone, 4,4'-diaminocyclohexylpropane-1,3, 4,4'-diaminocyclohexylpropane-2,2, 3,3'-dimethyl-4,4'-diaminodicyclohexylmethane, 3-aminomethyl-3,3,5-trimethylcyclohexylamine (isophoronediamine), 3(4)-aminomethyl-1-methylcyclohexylamine, (technical grade) bis-aminomethyltricylcodecane, octahydro-4,7-methanoinden-1,5-dimethaneamine or amines which, besides the at least two amino groups comprise any secondary amino groups, such as for example diethylenetriamine or triethylenetetramine.
In particular suitable are polyamines, especially diamines of the molecular weight mentioned above, which comprise one or more cycloaliphatic rings. Examples are mentioned above.

Suitable as component (c) further are thiol group-containing compounds, which generally are prepared by reacting hydroxyl group-containing compounds with thiol group-containing acids. Typically thiols which are suitable are monomeric, oligomeric, aliphatic or aromatic thiols. Examples of the isocyanate reactive compound (c) comprising at least one thiol group include a thiol-functional compound comprising at least two thiolfunctional groups and a compound comprising at least one thiol-functional group and one hydroxyl-functional group. Also mixtures of these compounds may be used in the compositions of the present invention. Suitable thiol group-containing compounds are generally prepared by reacting hydroxyl group-containing compounds with thiol group-containing acids, such as 3-mercaptopropionic acid, 2-mercaptopropionic acid, thio-salicylic acid, mercaptosuccinic acid, mercaptoacetic acid, or cysteine. Examples of suitable hydroxyl group-containing compounds are diols, triols, and tetraols, such as 1,4-butane diol, 1,6-hexane diol, 2,2-dimethyl-1,3-propane diol, 2-ethyl-2-propyl-1,3-propane diol, 1,2-, 1,3-, and 1,4-cyclohexane diols, and the corresponding cyclohexane dimethanol, 1,1,1-trimethylol propane, 1,2,3-trimethylol propane, and pentaerythritol. Examples of compounds prepared according to such a method include pentaerythritol tetrakis (3-mercaptopropionate), pentaerythritol tetrakis (2-mercaptoacetate), trimethylol propane tris (3-mercaptopropionate), trimethylol propane tris (2-mercaptopropion ate), and trimethylol propane tris (2mercaptoacetate). Good results have been obtained with trimethylol propane tris (3-mercapto propionate) and pentaerythritol tetrakis (3-mercapto propionate). A further example of a compound prepared according to such a method consists of a hyperbranched polyol core based on a starter polyol, e.g., trimethylol propane, and dimethylol propionic acid. This polyol is subsequently esterified with 3-mercaptopropionic acid and isononanoic acid. These methods are for example described in European patent application EP-A 0 448 224 and International patent application WO 93/17060.
Other syntheses to prepare compounds comprising at least two thiol-functional groups involve (i) the reaction of an aryl or alkyl halide with NaHS to introduce a pendent thiol group into the alkyl and aryl compounds, respectively; (ii) the reaction of a Grignard reagent with sulphur to introduce a pendent thiol group into the structure; (iii) the reaction of a polymercaptan with a polyolefin according to a Michael addition reaction, a nucleophilic reaction, an electrophilic reaction or a radical reaction; (iv) the reaction of a thiol functional alcohol and an isocyanate functional compound, and (v) the reduction of disulphides. The compound comprising at least one thiol-functional group and one hydroxyl-functional group may for example have a structure according to the following formula: T[(C₃H₃O)ₙCH₂CHOHCH₂SH]₃, with T being a triol such as trimethylol propane or glycerol. An example of such a compound is commercially available from Henkel under the trademark Henkel Capcure® 3/800.
Alternatively, the isocyanate reactive compound (c) comprising at least one thiol group is a resin having for example as a backbone a polyester resin, polyurethane resin, polyacrylate resin, or polyether resin. These isocyanate reactive compounds may also comprise hydroxyl groups. The isocyanate reactive compound comprising at least one thiol group is for example a polyester prepared from (1) at least one polycarboxylic acid or reactive derivatives thereof, (2) at least one polyol, and (3) at least one thiol-functional carboxylic acid. The polyesters preferably possess a branched structure. Branched polyesters are conventionally obtained through condensation of polycarboxylic acids or reactive derivatives thereof, such as the corresponding anhydrides or lower alkyl esters, with polyalcohols, when at least one of the reactants has a functionality of at least 3. Examples of suitable polycarboxylic acids or reactive derivatives thereof are tetrahydrophthalic acid, tetrahydrophthalic anhydride, hexahydrophthalic acid, hexahydrophthalic anhydride, methyl hexahydrophthalic acid, methyl hexahydrophthalic anhydride, dimethylcyclohexane dicarboxylate, 1,4-cyclohexane dicarboxylic acid, 1,3-cyclohexane dicarboxylic acid, phthalic acid, phthalic anhydride, isophthalic acid, terephthalic acid, 5-tert. butyl isophthalic acid, trimellitic anhydride, maleic acid, maleic anhydride, fumaric acid, succinic acid, succinic anhydride, dodecenyl succinic anhydride, dimethyi succinate, glutaric acid, adipic acid, dimethyl adipate, azelaic acid, and mixtures thereof.
Examples of suitable polyols include trimethylol propane, trimethylol ethane, glycerol, 1,2,6-hexanetriol, ethylene glycol, 1,2-propylene glycol, 1,3-propylene glycol, 2-methylpropane-1,3-diol, neopentyl glycol, 2-butyl-2-ethyl-1,3-propane diol, cyclohexane-1,4-dimethylol, the monoester of neopentyl glycol and hydroxypivalic acid, hydrogenated Bisphenol A, 1,5-pentane diol, 3-methylpentane diol, 1,6-hexane diol, 2,2,4-dimethyl pentane-1,3-diol, dimethylol propionic acid, pentaerythritol, di-trimethylol propane, dipentaerythritol, and mixtures thereof.

Specific examples of suitable thiols include pentaerythritol tetra(mercaptoacetate, pentaerythritol tetra(mercaptopropionate), 4,4'-thiobisbenzenethiol, dithiothreitol, mercaptoethanol, dodecane thiol, thioglycolic acid, 3-mercaptopropionic acid, or ethyleneglycol dimercaptoacetate.

The component (c) may also comprise an epoxy group containing resin or a resin which is an adduct of a primary and/or secondary amine with an epoxy group-containing resin or a resin which is an adduct of an amine-acid salt with a polyepoxide.
The epoxy material utilized singly or to form the adduct can be any monomeric or polymeric compound or mixture of compounds having an average of one or more epoxy groups per molecule. A particularly useful class of polyepoxides are the polyglycidyl ethers of polyphenols such as bisphenol A or polyepoxides produced from novolak resins or similar polyphenol resins. These epoxy resins are especially suitable for the preparation of amine adducts of epoxy resins which are based on primary or secondary amines and especially secondary amines and where the adducts are further reacted with an acid to provide catonic groups in the adduct.
Other polyglycidyl ethers of polyhydric alcohols may be employed, such a those based on ethylene glycol and the like as well as polyglycidyl esters of polycarboxlic acids. Polyepoxides derived from the epoxidation of an olefinically unsaturated alicyclic compound can also be used. Other epoxy-containing compounds and resins that may be employed include nitrogeneous diepoxides such as those disclosed in US 3365471; US 3391097; US 3450711; US 3312664; US 3503979 and GB 1172916 all of which are incorporated herein by reference.

Another class of polyepoxides which may be employed are acrylic polymers formed by copolymerizing an unsaturated epoxy-containing monomer such as, for example, glycidyl acrylic acid, glycidyl acrylates or methacrylates, a hydroxyl-containing unsaturated monomer such as a hydroxyalkyl ester of an acrylic acid or methacrylic acid and at least one other unsaturated monomer such as styrene, alpha-methylstryene vinyl toluene and the like or olefinic acids and esters of acrylic acid or methacrylic acid such as, methyl acrylate ethyl acrylate, methyl methacrylate and the like. These epoxy resins are especially suitable for the preparation of solubilized polyepoxide adducts having a quaternary ammonium salt group e.g., those having a backbone derived from the interpolymerization of an olefinically unsaturated glycidyl compound, a hydroxy alkyl ester of an acrylic acid or met acrylic acid and at least one other olefinically unsaturated monomer. Polyglycidyl ethers of a polyphenol may also be employed as epoxy resins in the preparation of the solubilized polyepoxide adducts having quaternary ammonium salt groups.
Epoxy resin which are an adduct of a primary and/or a secondary amine are for example obtained by reacting such epoxy resins with an amine such as a water soluble amino compound including mono- and dialkylamines such as methylamine, ethylamine, propylamine, butylamine, dimethylamine, diethylamine, dipropylamine, dibutylamine, methylbutylamine, and the like. Higher molecular weight monoamines may also be employed where it is preferred that the molecule is more flexible. Further, a mixture of low molecular weight and high molecular weight amines may also be employed to modify the resin properties. Quaternary ammonium group-containing epoxy resins are obtained by reacting the polyepoxide with an amine-acid salt, preferably a tertiary amine-acid salt, to form a quaternary amine salt group-containing resin. Primary and secondary amine-acid salts may be employed but the tertiary amine-acid salt is preferred. Examples of amine-acid salts which may be employed include amine salts of boric acid or an acid having a dissociation constant greater than that of boric acid and preferably an organic acid having a dissociation constant greater than about 1 x 10⁻⁵ such as lactic acid, acetic acid, formic acid, propionic acid, butyric acid, hydrochloric acid, phosphoric acid, sulfuric acid and the like. The amine-acid salt and the polyepoxide are reacted in the presence of water and the adduct thus obtained.
Further examples of such amine adducts of an epoxy group-containing resin are described in US 4031050, US 4017438 and examples of the resin containing active hydrogen atoms and quaternary ammonium groups prepared by the reaction of a polyepoxide with an amine are described in US 4101486, all of which are incorporated herein by reference.
The functional component reactive with the blocked isocyanate (c) for example also is a polyfunctional compound based on a ketimine blocked amine having at least one active amine hydrogen wherein the ketimin blocked amine is reacted with an epoxy compound. These compounds are for example obtained by reacting the diketimine of diethylene triamine and methyl isobutyl ketone with a polyepoxide.
Various specific isocyanate and thioisocyanate materials that are for example employed according to the present invention as well as functional compounds or components containing reactive hydrogen are further described in US 3084177; US 3240730; US 339212 and US 3392153 all of which are incorporated herein by reference.

Interesting therefore is a composition as described above, wherein the hydrogen donor component (c) is at least one compound selected from the group consisting of alcohols, polyols, phenols, boronic acids, carboxylic acids, sulfonic acids, amines, amides, lactams, ureas, urethanes, allophanates, biurets, acyl ureas, thioureas, hydrazones, oximes, amidines, hydroxylamines, hydrazones, hydroxamic acids, nitramines, diazoamino compounds, sulfonamides, thiols, polythiols, thiophenols, thioacids, halogen acids and compounds containing epoxid groups, in particular selected from the group consisting of alcohols, polyols, polythiols, phenols, amines, amides, hydroxylamines and compounds containing epoxid groups.

In particular interesting as component (c) are amines, hydroxyl-functional compounds and thiol compound.

The compositions contain the photolatent base, component (a), in an amount, for example, of from 0.01 to 20% by weight, preferably from 0.01 to 10% by weight, based on the total composition.
The compositions contain the blocked isocyanate, component (b), in an amount, for example, of from 5 to 95% by weight, preferably from 20 to 80% by weight, based on the total composition. The ration (b):(c) for example varies from about 2:1 to 1:2, preferably from 1.2:1 to 1:1.2. The molecular weight MW of the blocked isocyanate for examples ranges from about 100 to 50000, especially from 200 to 20000.

In addition to the photolatent base (a) the photopolymerizable composition may include various additives (d).

Additives (d) are for example additional coinitiators or sensitizers which shift or broaden the spectral sensitivity. In general these are aromatic carbonyl compounds, for example benzophenone, thioxanthone, anthraquinone and 3-acylcoumarin derivatives or dyes such as eosine, rhodamine and erythrosine dyes which improve the overall quantum yield by means, for example, of energy transfer or electron transfer. Examples of suitable dyes which can be added as coinitiators are triarylmethanes, for example malachite green, indolines, thiazines, for example methylene blue, xanthones, thioxanthones, oxazines, acridines or phenazines, for example safranine, and rhodamines of the formula 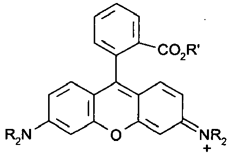 in which R is alkyl or aryl and R' is hydrogen or an alkyl or aryl radical, for example Rhodamine B, Rhodamine 6G or Violamine R, and also Sulforhodamine B or Sulforhodamine G. Likewise suitable are fluorones such as, for example, 5,7-diiodo-3-butoxy-6-fluorone.

Further specific examples of photosensitizers suitable as component (d) are
1.Thioxanthones Thioxanthone, 2-isopropylthioxanthone, 2-chlorothioxanthone, 1-chloro-4-propoxythioxanth-one, 2-dodecylthioxanthone, 2,4-diethylthioxanthone, 2,4-dimethylthioxanthone, 1-methoxy-carbonylthioxanthone, 2-ethoxycarbonylthioxanthone, 3-(2-methoxyethoxycarbonyl)-thioxanthone, 4-butoxycarbonylthioxanthone, 3-butoxycarbonyl-7-methylthioxanthone, 1-cyano-3-chlorothioxanthone, 1-ethoxycarbonyl-3-chlorothioxanthone, 1-ethoxycarbonyl-3-ethoxythio-xanthone, 1-ethoxycarbonyl-3-aminothioxanthone, 1-ethoxycarbonyl-3-phenylsulfurylthioxan-thone, 3,4-di-[2-(2-methoxyethoxy)ethoxycarbonyl]-thioxanthone, 1,3-dimethyl-2-hydroxy-9H-thioxanthen-9-one 2-ethylhexylether, 1-ethoxycarbonyl-3-(1-methyl-1-morpholinoethyl)-thioxanthone, 2-methyl-6-dimethoxymethyl-thioxanthone, 2-methyl-6-(1,1-dimethoxybenzyl)-thioxanthone, 2-morpholinomethylthioxanthone, 2-methyl-6-morpholinomethylthioxanthone, N-allylthioxanthone-3,4-dicarboximide, N-octylthioxanthone-3,4-dicarboximide, N-(1,1,3,3-tetramethylbutyl)-thioxanthone-3,4-dicarboximide, 1-phenoxythioxanthone, 6-ethoxycarbonyl-2-methoxythioxanthone, 6-ethoxycarbonyl-2-methylthioxanthone, thioxanthone-2-carboxylic acid polyethyleneglycol ester, 2-hydroxy-3-(3,4-dimethyl-9-oxo-9H-thioxanthon-2-yloxy)-N,N,N-trimethyl-1-propanaminium chloride;
2. Benzophenones benzophenone, 4-phenyl benzophenone, 4-methoxy benzophenone, 4,4'-dimethoxy benzophenone, 4,4'-dimethyl benzophenone, 4,4'-dichlorobenzophenone 4,4'-bis(dimethylamino)-benzophenone, 4,4'-bis(diethylamino)benzophenone, 4,4'-bis(methylethylamino)benzophenone, 4,4'-bis(p-isopropylphenoxy)benzophenone, 4-methyl benzophenone, 2,4,6-trimethylbenzophenone, 4-(4-methylthiophenyl)-benzophenone, 3,3'-dimethyl-4-methoxy benzophenone, methyl-2-benzoylbenzoate, 4-(2-hydroxyethylthio)-benzophenone, 4-(4-tolylthio)-benzophenone, 1-[4-(4-benzoyl-phenylsulfanyl)-phenyl]-2-methyl-2-(toluene-4-sulfonyl)-prop-an-1-one, 4-benzoyl-N,N,N-trimethylbenzenemethanaminium chloride, 2-hydroxy-3-(4-benzoylphenoxy)-N,N,N-trimethyl-1-propanaminium chloride monohydrate, 4-(13-acryloyl-1,4,7,10,13-pentaoxatridecyl)-benzophenone, 4-benzoyl-N,N-dimethyl-N-[2-(1-oxo-2-propenyl)oxy]ethyl-benzenemethanaminium chloride;
3. Coumarins Coumarin 1, Coumarin 2, Coumarin 6, Coumarin 7, Coumarin 30, Coumarin 102, Coumarin 106, Coumarin 138, Coumarin 152, Coumarin 153, Coumarin 307, Coumarin 314, Coumarin 314T, Coumarin 334, Coumarin 337, Coumarin 500, 3-benzoyl coumarin, 3-benzoyl-7-meth-oxycoumarin, 3-benzoyl-5,7-dimethoxycoumarin, 3-benzoyl-5,7-dipropoxycoumarin, 3-benzoyl-6,8-dichlorocoumarin, 3-benzoyl-6-chloro-coumarin, 3,3'-carbonyl-bis[5,7-di(propoxy)-coumarin], 3,3'-carbonyl-bis(7-methoxycoumarin), 3,3'-carbonyl-bis(7-diethylamino-coumarin), 3-isobutyroylcoumarin, 3-benzoyl-5,7-dimethoxy-coumarin, 3-benzoyl-5,7-diethoxy-coumarin, 3-benzoyl-5,7-dibutoxycoumarin, 3-benzoyl-5,7-di(methoxyethoxy)-coumarin, 3-benzoyl-5,7-di(allyloxy)coumarin, 3-benzoyl-7-dimethylaminocoumarin, 3-benzoyl-7-diethylami-nocoumarin, 3-isobutyroyl-7-dimethylaminocoumarin, 5,7-dimethoxy-3-(1-naphthoyl)-coumarin, 5,7-diethoxy-3-(1-naphthoyl)-coumarin, 3-benzoylbenzo[f]coumarin, 7-diethylamino-3-thi-enoylcoumarin, 3-(4-cyanobenzoyl)-5,7-dimethoxycoumarin, 3-(4-cyanobenzoyl)-5,7-diprop-oxycoumarin, 7-dimethylamino-3-phenylcoumarin, 7-diethylamino-3-phenylcoumarin, the coumarin derivatives disclosed in JP 09-179299-A and JP 09-325209-A, for example 7-[{4-chloro-6-(diethylamino)-S-triazine-2-yl}amino]-3-phenylcoumarin;
4. 3-(aroylmethylene)-thiazolines 3-methyl-2-benzoylmethylene-β-naphthothiazoline, 3-methyl-2-benzoylmethylene-benzothia-zoline, 3-ethyl-2-propionylmethylene-β-naphthothiazoline;
5. Rhodanines 4-dimethylaminobenzalrhodanine, 4-diethylaminobenzalrhodanine, 3-ethyl-5-(3-octyl-2-ben-zothiazolinylidene)-rhodanine, the rhodanine derivatives, formulae [1], [2], [7], disclosed in JP 08-305019A;
6. Other compounds acetophenone, 3-methoxyacetophenone, 4-phenylacetophenone, benzil, 4,4'-bis(dimethyla-mino)benzil, 2-acetylnaphthalene, 2-naphthaldehyde, dansyl acid derivatives, 9,10-anthraquinone, anthracene, pyrene, aminopyrene, perylene, phenanthrene, phenanthrenequinone, 9-fluorenone, dibenzosuberone, curcumin, xanthone, thiomichler's ketone, α-(4-dimethylaminobenzylidene) ketones, e.g. 2,5-bis(4-diethylaminobenzylidene)cyclopentanone, 2-(4-di-methylamino-benzylidene)-indan-1-one, 3-(4-dimethylamino-phenyl)-1-indan-5-yl-propenone, 3-phenylthiophthalimide, N-methyl-3,5-di(ethylthio)-phthalimide, N-methyl-3,5-di(ethylthio)-phthalimide, phenothiazine, methylphenothiazine, amines, e.g. N-phenylglycine, ethyl 4-dimethylaminobenzoate, butoxyethyl 4-dimethylaminobenzoate, 4-dimethylaminoacetophen-one, triethanolamine, methyldiethanolamine, dimethylaminoethanol, 2-(dimethylamino)ethyl benzoate, poly(propylenegylcol)-4-(dimethylamino) benzoate.

Likewise suitable in this context are combinations of dyes with borates, as are described, for example, in US 4,772,530, GB 2 307 474, GB 2 307 473, GB 2 307 472 and EP 775 706. The compositions may comprise as further additive (d) a photoreducable dye, e.g., xanthene-, benzoxanthene-, benzothioxanthene, thiazine-, pyronine-, porphyrine- or acridine dyes, and/or trihalogenmethyl compounds which can be cleaved by irradiation. Similar compositions are for example described in EP 445624.

Particular preference is given to substituted benzophenones or thioxanthones. Examples of suitable benzophenones are benzophenone, 4,4'-bis(dimethylamino)benzophenone, 4,4'-bis-(diethylamino)benzophenone, 4,4'-bis(ethylmethylamino)benzophenone, 4,4'-diphenylbenzo-phenone, 4,4'-diphenoxybenzophenone, 4,4'-bis(p-isopropylphenoxy)benzophenone, 4-methylbenzophenone, 2,4,6-trimethylbenzophenone, 4-phenylbenzophenone, 2-methoxycar-bonylbenzophenone, 4-benzoyl-4'-methyldiphenyl sulfide, 4-methoxy-3,3'-methylbenzophenone, isopropylthioxanthone, chlorothioxanthone, 1-chloro-4-propoxythioxanthone, 2,4-dimethylthioxanthone, 2,4-diethylthioxanthone, 1,3-dimethyl-2-(2-ethylhexyloxy)thioxanthone. Likewise preferred are mixtures of benzophenones and/or thioxanthones such as, for example, a mixture of benzophenone and 4-methylbenzophenone or of 4-methylbenzophenone and 2,4,6-trimethylbenzophenone.

Interesting therefore also is a composition as described above comprising as further additive (d) a photosensitizer compound selected from the group consisting of benzophenone and its derivatives, thioxanthone and its derivatives, anthraquinone and its derivatives or coumarin and its derivatives or dyes such as oxazines, acridines, phenazines and rhodamines, in particular benzophenone and its derivatives, thioxanthone and its derivatives, anthraquinone and its derivatives or coumarin and its derivatives. Examples of the corresponding derivatives are collected in the list above.

Further customary additives (d), depending on the intended use, are optical brighteners, fillers, pigments, dyes, wetting agents, levelling assistants, antistatics, flow improvers and adhesion promoters, antioxidants, light stabilizers, e.g. UV-absorbers, for example those of the hydroxybenzotriazole, hydroxyphenyl-benzophenone, oxalamide or hydroxyphenyl-s-triazine type. These compounds can be used individually or in mixtures, with or without sterically hindered amines (HALS).

The compositions may also comprise dyes and/or white and colored pigments. Depending on the kind of application organic as well as anorganic pigments are used. Such additives are known to the person skilled in the art, some examples are titan dioxide pigments, e.g. of the rutile type or anatas type, carbon black Russ, zinc oxide, such as zink white, iron oxide, such as iron oxide yellow, iron oxide red, chromium yellow, chromium green, nickel titanium yellow, ultramarine blue, cobalt blue, bismuth vanadate, cadmiumyellow or cadmium red. Examples of organic pigments are mono- or bisazo pigments, as well as metal complexes thereof, phthalocyanine pigments, polycyclic pigments, such as perylene-, anthraquinone-, thioindigo-, chinacridone- or triphenylmethane pigments, as well as diketo-pyrrolo-pyrole-, isoindolinone-, e.g. tetrachlorisoindolinone-, isoindoline-, dioxazin-, benzimidazolone- and chinophthalone pigments.
The pigments are employed alone or in combination in the compositions according to the invention.
Depending on the intended use the pigments are used in amount customary in the art, for example in an amount of 1-60% by weight, or 10-30% by weight, based on the whole formulation.
The compositions may also comprise organic dyes of different classes. Examples are azo dyes, methin dyes, anthraquinone dyes or metal complex dyes. Customary concentrations are for example 0.1-20 %, in particular 1-5 %, based on the whole formulation.

The choice of additive is made depending on the field of application and on properties required for this field. The additives described above are customary in the art and accordingly are added in amounts which are usual in the respective application.

In certain cases it may be of advantage to use mixtures of two or more of the photolatent base compounds (a).

In addition to the above-described base-catalysable (curable) formulation, comprising components (a), (b) and (c), the composition may also include other binders as well. Addition of further olefinically unsaturated compounds, for example, is possible.
Accordingly, the composition comprising components (a), (b) and (c) for example may be used in admixture with radically curable components (unsaturated compounds) and optionally a radical initiator, for example a thermal initiator or a photoinitiator.
The unsaturated compounds for example include one or more olefinically double bonds. They are of low molecular mass (monomeric) or higher molecular mass (oligomeric). Examples of monomers having a double bond are alkyl or hydroxyalkyl acrylates or methacrylates, such as methyl, ethyl, butyl, 2-ethylhexyl or 2-hydroxyethyl acrylate, isobornyl acrylate, methyl methacrylate or ethyl methacrylate. Silicone acrylates are also of interest. Further examples are acrylonitrile, acrylamide, methacrylamide, N-substituted (meth)acrylamides, vinyl esters such as vinyl acetate, vinyl ethers such as isobutyl vinyl ether, styrene, alkyl- and halostyrenes, N-vinylpyrrolidone, vinyl chloride or vinylidene chloride.
Examples of monomers having two or more double bonds are the diacrylates of ethylene glycol, propylene glycol, neopentyl glycol, hexamethylene glycol or bisphenol A, 4,4'-bis-(2-acryloyloxyethoxy)diphenylpropane, trimethylolpropane triacrylate, pentaerythritol triacrylate or tetraacrylate, vinyl acrylate, divinyl benzene, divinyl succinate, diallyl phthalate, triallyl phosphate, triallyl isocyanurate or tris(2-acryloylethyl) isocyanurate.
Examples of polyunsaturated compounds of relatively high molecular mass (oligomers) are acrylated epoxy resins, acrylated polyesters or polyesters containing vinyl ether groups or epoxy groups, polyurethanes and polyethers. Further examples of unsaturated oligomers are unsaturated polyester resins which are mostly prepared from maleic acid, phthalic acid and one or more diols and have molecular weights of from about 500 to 3000. In addition it is also possible to employ vinyl ether monomers and oligomers, and also maleate-terminated oligomers with polyester, polyurethane, polyether, polyvinyl ether and epoxy main chains. In particular, combinations of vinyl ether-functional oligomers and polymers as are described in WO 90/01512 are very suitable. Also suitable, however, are copolymers of vinyl ether and maleic acid functionalized monomers. Unsaturated oligomers of this kind can also be referred to as prepolymers.
Particularly suitable examples are esters of ethylenically unsaturated carboxylic acids and polyols or polyepoxides, and polymers having ethylenically unsaturated groups in the chain or in side groups, such as unsaturated polyesters, polyamides and polyurethanes and copolymers thereof, alkyd resins, polybutadiene and butadiene copolymers, polyisoprene and isoprene copolymers, polymers and copolymers having (meth)acrylic groups in side chains, and mixtures of one or more such polymers.

If, in addition, use is made of such free-radically curable monomers, oligomers/polymers then it is judicious to add an initiator which dissociates into free radicals. Suitable are thermal initiators or, in case that the composition is a photocurable composition, a photoinitiator. Thus, the curing process can be assisted by adding a component which under thermal conditions forms free radicals, for example an azo compound such as 2,2'-azobis(4-methoxy-2,4-dimethylvaleronitrile), a triazene, diazo sulfide, pentazadiene or a peroxy compound, for instance a hydroperoxide or peroxycarbonate, for example t-butyl hydroperoxide, as described for example in EP 245639.
Suitable photoinitiators are known in the art and are produced industrially. Examples are benzophenone, benzophenone derivatives, such as 2,4,6-trimethylbenzophenone and 4-methylbenzophenone, acetophenone, acetophenone derivatives, for example α-hydroxycycloalkyl phenyl ketones, especially α-hydroxycyclohexyl phenyl ketone, 2-hydroxy-2-methyl-1-phenylpropanone, 1-[4-(2-hydroxyethoxy)-phenyl]-2-hydroxy-2-methyl-1-propan-1-one, 2-hydroxy-1-{4-[4-(2-hydroxy-2-methyl-propionyl)-benzyl]-phenyl}-2-methyl-propan-1-one, 2-hydroxy-1-{4-[4-(2-hydroxy-2-methyl-propionyl)-phenoxy]-phenyl}-2-methyl-propan-1-one, dialkoxyacetophenones, e.g. 2,2-dimethoxy-1,2-diphenylethan-1-one α-aminoacetophenones, such as (4-methylthiobenzoyl)-1-methyl-1-morpholinoethane, (4-morpholinobenzoyl)-1-benzyl-1-dimethylaminopropane, 2-dimethylamino-2-(4-methylbenzyl)-1-(4-morpholin-4-yl-phenyl)-butan-1-one, 2-benzyl-1-(3,4-dimethoxy-phenyl)-2-dimethylamino-butan-1-one, 4-aroyl-1,3-dioxolanes, benzoin alkyl ethers and benzil ketals, such as benzil dimethyl ketal, phenylglyoxalates and derivatives thereof, dimeric phenylglyoxalates, e.g. oxo-phenyl-acetic acid 2-[2-(2-oxo-2-phenyl-acetoxy)-ethoxy]-ethyl ester; monoacylphosphine oxides, such as (2,4,6-trimethylbenzoyl)phenylphosphine oxide, bisacylphosphine oxides, such as bis(2,6-dimethoxybenzoyl)(2,4,4-trimethylpent-1-yl)phosphine oxide, bis(2,4,6-trimethylbenzoyl)phenylphosphine oxide or bis(2,4,6-trimethylbenzoyl)(2,4-dipentoxyphenyl)phosphine oxide, trisacylphosphine oxides, oxime esters, e.g. 1,2-octanedione 1-[4-(phenylthio)phenyl]-2-(O-benzoyloxime); ethanone 1-[9-ethyl-6-(2-methylbenzoyl)-9H-carbazol-3-yl]-1-(O-acetyloxime), 9H-thioxanthene-2-carboxaldehyde 9-oxo-2-(O-acetyloxime), ethanone 1-[9-ethyl-6-(4morpholinobenzoyl)-9H-carbazol-3-yl]-1-(O-acetyloxime); ferrocenium compounds or titanocenes, such as dicyclopentadienylbis(2,6-difluoro-3-pyrrolophenyl)titanium, for example.
Examples are specified in EP 284561. Polymer systems of this kind, in which curing/crosslinking takes place by different mechanisms, are also referred to as hybrid systems.

The compositions can also have added to them non-reactive binders, which is particularly judicious if the photopolymerizable compounds are liquid or viscous substances. The amount of the non-reactive binder is, for example, 5-95%, preferably 10-90% and, in particular, 40-90% by weight, based on the overall solids content. The choice of non-reactive binder is made in accordance with the field of use and with the properties required for this use, such as for example the possibility for development in aqueous and organic solvent systems, adhesion to substrates, and sensitivity to oxygen.

Examples of suitable binders are polymers having a molecular weight of around 5000-2,000,000, preferably 10,000-1,000,000.Examples are: homo- and copolymeric acrylates and methacrylates, for example copolymers of methyl methacrylate/ethyl acrylate/methacrylic acid, poly(alkyl methacrylates), poly(alkyl acrylates); cellulose esters and ethers, such as cellulose acetate, cellulose acetate butyrate, methylcellulose, ethylcellulose; polyvinylbutyral, polyvinylformal, cyclized rubber, polyethers such as polyethylene oxide, polypropylene oxide, polytetrahydrofuran; polystyrene, polycarbonate, polyurethane, chlorinated polyolefins, polyvinyl chloride, copolymers of vinyl chloride/vinylidene chloride, copolymers of vinylidene chloride with acrylonitrile, methyl methacrylate and vinyl acetate, polyvinyl acetate, copoly(ethylene/vinyl acetate), polymers such as polycaprolactam and poly(hexamethylene adipamide) and polyesters such as poly(ethylene glycol terephtalate) and poly(hexamethylene glycol succinate).

If, in addition, use is made of such free-radically curable monomers, oligomers/polymers then the photopolymerizable composition may include various additives. Examples of these are thermal inhibitors, which are intended to prevent premature polymerization, examples being hydroquinone, hydroquinine derivatives, p-methoxyphenol, β-naphthol or sterically hindered phenols, such as 2,6-di-tert-butyl-p-cresol. In order to increase the stability on storage in the dark it is possible, for example, to use copper compounds, such as copper naphthenate, stearate or octoate, phosphorus compounds, for example triphenylphosphine, tributylphosphine, triethyl phosphite, triphenyl phosphite or tribenzyl phosphite, quaternary ammonium compounds, for example tetramethylammonium chloride or trimethylbenzylammonium chloride, or hydroxylamine derivatives, for example N-diethylhydroxylamine. To exclude atmospheric oxygen during the polymerization it is possible to add paraffin or similar wax-like substances which, being of inadequate solubility in the polymer, migrate to the surface in the beginning of polymerization and form a transparent surface layer which prevents the ingress of air. It is also possible to apply an oxygen-impermeable layer. Light stabilizers which can be added in a small quantity are UV absorbers, for example those of the hydroxyphenylbenzotriazole, hydroxyphenyl-benzophenone, oxalamide or hydroxyphenyl-s-triazine type. These compounds can be used individually or in mixtures, with or without sterically hindered amines (HALS).
Examples of such UV absorbers and light stabilisers are disclosed in WO 04/074328 Case22841, page 12, line 9 to page14, line 23, said disclosure hereby is incorporated by reference.

To accelerate the photopolymerization it is possible to add amines, for example triethanolamine, N-methyldiethanolamine, p-dimethylaminobenzoate or Michler's ketone. The action of the amines can be intensified by the addition of aromatic ketones of the benzophenone type. Examples of amines which can be used as oxygen scavengers are substituted N,N-dialkylanilines, as are described in EP 339841. Other accelerators, coinitiators and au-toxidizers are thiols, thioethers, disulfides, phosphonium salts, phosphine oxides or phosphines, as described, for example, in EP 438123, in GB 2180358 and in JP Kokai Hei 6-68309.
It is further possible to add chain transfer agents which are customary in the art to the compositions. Examples are mercaptanes, amines and benzothiazol.

In some cases it may be advantageous to carry out heating during or after exposure to light. In this way it is possible in many cases to accelerate the crosslinking reaction.

The compositions can be employed for various purposes, for example as printing inks, as clearcoats, as white paints, for example for wood or metal, as coatings, inter alia for paper, wood, metal or plastic, as powder coatings, as daylight-curable exterior coatings for marking buildings and roads, for photographic reproduction processes, for holographic recording materials, for image recording processes or for the production of printing plates which can be developed using organic solvents or aqueous-alkaline media, for the production of masks for screen printing, as dental filling materials, as adhesives, including pressure-sensitive adhesives, for sealings, as laminating resins, as etch resists or permanent resists and as solder masks for electronic circuits, for potting components, for mouldings, for the production of three-dimensional articles by mass curing (UV curing in transparent moulds) or by the stereolithography process, as is described, for example, in US 4575330, for the preparation of composite materials (for example styrenic polyesters, which may contain glass fibres and/or other fibres and other assistants) and other thick-layer compositions, for the coating or encapsulation of electronic components, or as coatings for optical fibres.

Of particular interest is the use of the compositions for preparing decorative coatings, such as exterior coatings on substrates of all kinds, for example buildings, fences, chipboard panels, and as a coating on stone, concrete or metal, for the coating of vehicles, for example, such as cars, railways or aircraft. The compositions may likewise be used in automotive OEM fininshing and automotive refinish, and also for the finishing of car bodies, plastic parts for cars and body-mounted car parts. The initiators described herein can be used in a multicoat system in the surfacer, base coat or clearcoat. Their use in pigmented topcoats is also possible.

In surface coatings, it is common to use mixtures of a prepolymer with polyunsaturated monomers which also contain a monounsaturated monomer. The prepolymer here is primarily responsible for the properties of the coating film, and varying it allows the skilled worker to influence the properties of the cured film. The polyunsaturated monomer functions as a crosslinker, which renders the coating film insoluble. The monounsaturated monomer functions as a reactive diluent, by means of which the viscosity is reduced without the need to use a solvent.

The photocurable compositions are suitable, for example, as coating materials for substrates of all kinds, examples being wood, textiles, paper, ceramic, glass, plastics such as polyesters, polyethylene terephthalate, polyolefins or cellulose acetate, especially in the form of films, and also metals such as Al, Cu, Ni, Fe, Zn, Mg or Co and GaAs, Si or SiO₂, on which it is the intention to apply a protective coating or, by imagewise exposure, an image.

The substrates can be coated by applying a liquid composition, a solution or suspension to the substrate. The choice of solvent and the concentration depend predominantly on the type of composition and the coating process. The solvent should be inert: in other words, it should not undergo any chemical reaction with the components and should be capable of being removed again after the coating operation, in the drying process. Examples of suitable solvents are ketones, ethers and esters, such as methyl ethyl ketone, isobutyl methyl ketone, cyclopentanone, cyclohexanone, N-methylpyrrolidone, dioxane, tetrahydrofuran, 2-methoxyethanol, 2-ethoxyethanol, 1-methoxy-2-propanol, 1,2-dimethoxyethane, ethyl acetate, n-butyl acetate and ethyl 3-ethoxypropionate.
Using known coating processes, the solution is applied uniformly to a substrate, for example by spin coating, dip coating, knife coating, curtain coating, brushing, spraying - especially electrostatic spraying - and reverse roll coating and by electrophoretic deposition. It is also possible to apply the photosensitive layer to a temporary, flexible support and then to coat the final substrate, for example a copper-clad circuit board, by means of layer transfer via lamination.

The amount applied (layer thickness) and the nature of the substrate (layer support) are functions of the desired field of application. The range of layer thicknesses generally comprises values from about 0.1 µm to more than 100 µm.

The compositions are also suitable for use in uv-curing adhesives. Said adhesives can be hot melt adhesives as well waterborne or solvent borne adhesives. In particular suitable are pressure-sensitive adhesives (PSA), for example uv-curable hot melt pressure sensitive adhesives. Said adhesives for example comprise at least one rubber component, at least one resin component as tackyfier and at least one oil component, for example in the weight ratio 30:50:20. Suitable tackyfier are natural or synthetic resins. The person skilled in the art is aware of suitable corresponding compounds as well as of suitable oil components or rubbers.
The pre-polymerized adhesives containing the blocked isocyanates can for example be processed at high temperature and coated onto the substrate following the hotmelt process, afterwards full cure is achieved by an additional curing step involving the blocked isocyanates, which is realized by photoactivation of the photolatent catalyst.
Hotmelt adhesives are interesting as pressure sensitive adhesives and suitable to replace the use of solvent base compositions, which from an environmental point of view are un wanted. The hotmelt extrusion process in order to achieve the high flow viscosity necessitates high application temperatures. The compositions comprising blocked isocyanates are suitable as crosslinkers in the preparation of a hotmelt coating, where the corsslinkersenter into a chemical reaction with the functional comonomers of the (meth)acrylate PSA. After the coating operation, the PSAs are first crosslinked thermally, or implementing the dual crosslinking mechanism, the PSA is subsequently crosslinked with UV light. UV crosslinking irradiation takes place by means of shortwave ultraviolet radiation in a wavelength range from 200 to 400 nm, depending on the UV photoinitiator. Such systems and processes are for example described in US 2006/0052472.

The compositions are also used in "powder coating compositions" or "powder coatings", either thermal curing or radiation-curable curing ones. By "powder coating compositions" or "powder coatings" is meant the definition as described in "Ullmann's Encyclopedia of Industrial Chemistry, 5th, Completely Revised Edition, Vol. A 18", pages 438 to 444 (1991) in Section 3.4. That is powder coatings are formed by thermoplastic or bakable, crosslinkable polymers, which are applied in powder form to, predominantly metallic, substrates. The way in which the powder is brought into contact with the workpiece that is to be coated typifies the various application techniques, such as electrostatic powder spraying, electrostatic fluidized-bed sintering, fixed bed sintering, fluidized-bed sintering, rotational sintering or centrifugal sintering.
Preferred organic film-forming binders for the powder coating compositions are stoving systems based, for example, on epoxy resins, polyester-hydroxyalkylamides, polyester-glycolurils, epoxy-polyester resins, polyester-triglycidyl isocyanurates, hydroxy-functional polyester-blocked polyisocyanates, hydroxy-functional polyester-uretdiones, acrylate resins with hardener, or mixtures of such resins.
Radiation-curable powder coatings are for example based on solid resins and monomers containing reactive double bonds, for example maleates, vinyl ethers, acrylates, acrylamides and mixtures thereof. A free-radically UV-curable powder coating -in admixture with the composition described herein- can for example be formulated by mixing unsaturated polyester resins with solid acrylamides (for example methyl methylacrylamidoglycolate), acrylates, methacrylates or vinyl ethers and a free-radical photoinitiator, such formulations being as described, for example, in the paper "Radiation Curing of Powder Coating", Conference Proceedings, Radtech Europe 1993 by M. Wittig and Th. Gohmann. The powder coatings may also comprise binders as are described, for example, in DE 4228514 and in EP 636669.
The powder coatings may additionally comprise white or coloured pigments. For example, preferably rutiletitanium dioxide can be employed in concentrations of up to 50% by weight in order to give a cured powder coating of good hiding power. The procedure normally comprises electrostatic or tribostatic spraying of the powder onto the substrate, for example metal or wood, melting of the powder by heating, and, after a smooth film has formed, radiation-curing of the coating with ultraviolet and/or visible light.

The composition further may be employed for the preparation of printing inks. Printing inks in general are known to the person skilled in the art, are used widely in the art and are described in the literature. They are, for example, pigmented printing inks and printing inks coloured with dyes.
A printing ink is, for example, a liquid or paste-form dispersion that comprises colorants (pigments or dyes), binders and also optionally solvents and/or optionally water and additives. In a liquid printing ink, the binder and, if applicable, the additives are generally dissolved in a solvent. Customary viscosities in the Brookfield viscometer are, for example, from 20 to 5000 mPa·s, for example from 20 to 1000 mPa·s, for liquid printing inks. For paste-form printing inks, the values range, for example, from 1 to 100 Pa·s, preferably from 5 to 50 Pa·s. The person skilled in the art will be familiar with the ingredients and compositions of printing inks.
Suitable pigments for printing inks, employed in the printing ink formulations customary in the art, are generally known and widely described. Printing inks comprise pigments advantageously in a concentration of, for example, from 0.01 to 40 % by weight, preferably from 1 to 25 % by weight, especially from 5 to 10 % by weight, based on the total weight of the printing ink.
The printing inks can be used, for example, for intaglio printing, flexographic printing, screen printing, offset printing, lithography or continuous or dropwise ink-jet printing on material pretreated in accordance with the process of the invention using generally known formulations, for example in publishing, packaging or shipping, in logistics, in advertising, in security printing or in the field of office equipment. Suitable printing inks are both solvent-based printing inks and water-based printing inks.
Of interest are, for example, printing inks based on aqueous acrylate. Such inks are to be understood as including polymers or copolymers that are obtained by polymerisation of at least one monomer containing a group -(C=CH₂)-(C=O)-O- or -(C=CH₂)-(C=O)-N-, and that are dissolved in water or a water-containing organic solvent. Suitable organic solvents are water-miscible solvents customarily used by the person skilled in the art, for example alcohols, such as methanol, ethanol and isomers of propanol, butanol and pentanol, ethylene glycol and ethers thereof, such as ethylene glycol methyl ether and ethylene glycol ethyl ether, and ketones, such as acetone, ethyl methyl ketone or cyclo, for example isopropanol. Water and alcohols are preferred.
Suitable printing inks comprise, for example, as binder primarily an acrylate polymer or copolymer and the solvent is selected, for example, from the group consisting of water, C₁-C₅alcohols, ethylene glycol, 2-(C₁-C₅alkoxy)-ethanol, acetone, ethyl methyl ketone and any mixtures thereof.
In addition to the binder, the printing inks may also comprise customary additives known to the person skilled in the art in customary concentrations.
For intaglio or flexographic printing, a printing ink is usually prepared by dilution of a printing ink concentrate and can then be used in accordance with methods known *per se.*
The printing inks may, for example, also comprise alkyd systems that dry oxidatively.
The printing inks are dried in a known manner customary in the art, optionally with heating of the coating.
A suitable aqueous printing ink composition comprises, for example, a pigment or a combination of pigments, a dispersant and a binder.
Dispersants that come into consideration include, for example, customary dispersants, such as water-soluble dispersants based on one or more arylsulfonic acid/formaldehyde condensation products or on one or more water-soluble oxalkylated phenols, non-ionic dispersants or polymeric acids.
The arylsulfonic acid/formaldehyde condensation products are obtainable, for example, by sulfonation of aromatic compounds, such as naphthalene itself or naphthalene-containing mixtures, and subsequent condensation of the resulting arylsulfonic acids with formaldehyde. Such dispersants are known and are described, for example, in US 5186846 and DE 19727767. Suitable oxalkylated phenols are likewise known and are described, for example, in US 4218218 and DE 19727767. Suitable non-ionic dispersants are, for example, alkylene oxide adducts, polymerisation products of vinylpyrrolidone, vinyl acetate or vinyl alcohol and co- or ter-polymers of vinyl pyrrolidone with vinyl acetate and/or vinyl alcohol. It is also possible, for example, to use polymeric acids which act both as dispersants and as binders.
Examples of suitable binder components that may be mentioned include acrylate-group-containing, vinyl-group-containing and/or epoxy-group-containing monomers, prepolymers and polymers and mixtures thereof. Further examples are melamine acrylates and silicone acrylates. The acrylate compounds may also be non-ionically modified (e.g. provided with amino groups) or ionically modified (e.g. provided with acid groups or ammonium groups) and used in the form of aqueous dispersions or emulsions (e.g. EP-A-704 469, EP-A-12 339). Furthermore, in order to obtain the desired viscosity the solventless acrylate polymers can be mixed with so-called reactive diluents, for example vinyl-group-containing monomers. Further suitable binder components are epoxy-group-containing compounds.
The printing ink compositions may also comprise as additional component, for example, an agent having a water-retaining action (humectant), e.g. polyhydric alcohols, polyalkylene glycols, which renders the compositions especially suitable for ink-jet printing.
It will be understood that the printing inks may comprise further auxiliaries, such as are customary especially for (aqueous) ink-jet inks and in the printing and coating industries, for example preservatives (such as glutardialdehyde and/or tetramethylolacetyleneurea, anti-oxidants, degassers/defoamers, viscosity regulators, flow improvers, anti-settling agents, gloss improvers, lubricants, adhesion promoters, anti-skin agents, matting agents, emulsifiers, stabilisers, hydrophobic agents, light stabilisers, handle improvers and antistatics. When such agents are present in the compositions, their total amount is generally ≤ 1 % by weight, based on the weight of the preparation.
Suitable printing inks include, for example, those comprising a dye (with a total content of dyes of e.g. from 1 to 35 % by weight, based on the total weight of the ink).
Dyes suitable for colouring such printing inks are known to the person skilled in the art and are widely available commercially, e.g. from Ciba Spezialitätenchemie AG, Basel.
Such printing inks may comprise organic solvents, e.g. water-miscible organic solvents, for example C₁-C₄alcohols, amides, ketones or ketone alcohols, ethers, nitrogen-containing heterocyclic compounds, polyalkylene glycols, C₂-C₆alkylene glycols and thioglycols, further polyols, e.g. glycerol and C₁-C₄alkyl ethers of polyhydric alcohols, usually in an amount of from 2 to 30 % by weight, based on the total weight of the printing ink.
The printing inks may also, for example, comprise solubilisers, e.g. ε-caprolactam.
The printing inks may, *inter alia* for the purpose of adjusting the viscosity, comprise thickeners of natural or synthetic origin. Examples of thickeners include commercially available alginate thickeners, starch ethers or locust bean flour ethers. The printing inks comprise such thickeners e.g. in an amount of from 0.01 to 2 % by weight, based on the total weight of the printing ink.
It is also possible for the printing inks to comprise buffer substances, for example borax, borate, phosphate, polyphosphate or citrate, in amounts of e.g. from 0.1 to 3 % by weight, in order to establish a pH value of e.g. from 4 to 9, especially from 5 to 8.5.
As further additives, such printing inks may comprise surfactants or humectants. Surfactants that come into consideration include commercially available anionic and non-ionic surfactants. Humectants that come into consideration include, for example, urea or a mixture of sodium lactate (advantageously in the form of a 50 to 60 % aqueous solution) and glycerol and/or propylene glycol in amounts of e.g. from 0.1 to 30 % by weight, especially from 2 to 30 % by weight, in the printing inks.
Furthermore, the printing inks may also comprise customary additives, for example foam-reducing agents or especially substances that inhibit the growth of fungi and/or bacteria. Such additives are usually used in amounts of from 0.01 to 1 % by weight, based on the total weight of the printing ink.
The printing inks may also be prepared in customary manner by mixing the individual components together, for example in the desired amount of water.
As already mentioned, depending upon the nature of the use, it may be necessary for e.g. the viscosity or other physical properties of the printing ink, especially those properties which influence the affinity of the printing ink for the substrate in question, to be adapted accordingly.
The printing inks are also suitable, for example, for use in recording systems of the kind in which a printing ink is expressed from a small opening in the form of droplets which are directed towards a substrate on which an image is formed. Suitable substrates are, for example, textile fibre materials, paper, plastics or aluminium foils pretreated by the process according to the invention. Suitable recording systems are e.g. commercially available ink-jet printers.
Preference is given to printing processes in which aqueous printing inks are used.

The radiation-sensitive compositions described herein can also be subjected to imagewise exposure. In this case they are used as negative resists. They are suitable for electronics (galvanoresists, etch resists and solder resists), for the production of printing plates, such as offset printing plates, flexographic and relief printing plates or screen printing plates, for the production of marking stamps, and can be used for chemical milling or as microresists in the production of integrated circuits. There is a correspondingly wide range of variation in the possible layer supports and in the processing conditions of the coated substrates.

The term "imagewise" exposure relates both to exposure through a photomask containing a predetermined pattern, for example a slide, exposure by a laser beam which is moved under computer control, for example, over the surface of the coated substrate and so generates an image, and irradiation with computer-controlled electron beams.
Following the imagewise exposure of the material and prior to developing, it may be advantageous to carry out a brief thermal treatment, in which only the exposed parts are thermally cured. The temperatures employed are generally 50-150°C and preferably 80-130°C; the duration of the thermal treatment is generally between 0.25 and 10 minutes.
A further field of use for photocuring is that of metal coating, for example the surface-coating of metal panels and tubes, cans or bottle tops, and photocuring on polymer coatings, for example of floor or wall coverings based on PVC.

Examples of the photocuring of paper coatings are the colourless varnishing of labels, record sleeves or book covers.

The use of the compositions for preparing shaped articles made from composite compositions is likewise of interest. The composite composition is made up of a self-supporting matrix material, for example a glass-fibre fabric, or else, for example, of plant fibres [cf. K.-P. Mieck, T. Reussmann in Kunststoffe 85 (1995), 366-370], which is impregnated with the photocuring formulation. Shaped articles which are produced from compositions described herein are of high mechanical stability and resistance. The compositions can also be used in moulding, impregnating and coating compositions, as are described, for example, in EP 007086. Examples of such compositions are fine coating resins on which stringent requirements are placed with respect to their curing activity and resistance to yellowing, or fibre-reinforced mouldings such as planar or longitudinally or transversely corrugated light diffusing panels.

The sensitivity of the novel compositions to radiation generally extends from about 190 nm through the UV region and into the infrared region (about 20,000 nm, in particular 1200 nm), especially from 190 nm to 650 nm, and therefore spans a very broad range. Suitable radiation is present, for example, in sunlight or light from artificial light sources. Consequently, a large number of very different types of light sources are employed. Both point sources and arrays ("lamp carpets") are suitable. Examples are carbon arc lamps, xenon arc lamps, medium-, super high-, high- and low-pressure mercury lamps, possibly with metal halide dopes (metal-halogen lamps), microwave-stimulated metal vapour lamps, excimer lamps, superactinic fluorescent tubes, fluorescent lamps, argon incandescent lamps, electronic flashlights, photographic flood lamps, electron beams and X-rays. The distance between the lamp and the substrate to be exposed in accordance with the invention may vary depending on the intended application and the type and output of lamp, and may be, for example, from 2 cm to 150 cm. Laser light sources, for example excimer lasers, such as krypton F lasers for exposure at 248 nm are also suitable. Lasers in the visible region can also be employed.
Alternatively, the actinic radiation is provided by light emitting diodes (LED), e.g. UV light emitting diodes (UV-LED). Said LEDs allow instant on and off switching of the radiation source. Further, UV-LEDs generally have a narrow wavelength distribution and offer the possibility to customize the peak wavelength and also provide an efficient conversion of electric energy to UV radiation.
Depending on the light source used it is advantageous in many cases to employ a sensitizer, as described above, whose absorption spectrum coincides as closely as possible to the emission spectrum of the radiation source.

The invention therefore provides a process for crosslinking a blocked isocyanate (b) and an H-donor (c), by admixing said components with a photolatent base catalyst (a) of the formula I as defined in claim 1 and irradiating the composition with light of a wavelength range of 200-650 nm

Subject of the invention moreover is the use of the composition as described above for the preparation of adhesives, coatings, sealings, potting components, printing inks, moulding compounds, or photostructured layers.
as well as a process as described above for the preparation of adhesives, coatings, sealings, potting components, printing inks, moulding compounds or photostructured layers.

Another embodiment is a coated substrate coated on at least one surface with a composition as described above; as well as a polymerized or crosslinked composition as described above.

The examples which follow illustrate the invention in more detail, without restriciting the scope claims. Parts and percentages are, as in the remainder of the description and in the claims, by weight, unless stated otherwise. Where alkyl radicals having more than three carbon atoms are referred to in the examples without any mention of specific isomers, the n-isomers are meant in each case.

The blocked isocyanates are prepared according to the procedure reported in WO 03/004545 (Bayer AG).

### Preparation of Product 1

In a 250 ml three-neck flask equipped with a mechanical stirrer, thermometer, reflux condenser and dropping funnel, 42.7 g (0.3 mol) methyl 2-oxocyclopentanecarboxylic acid (Fluka 29785) are dissolved in 20 g butyl acetate. 1 g Zinc 2-ethylhexanoate (80% in mineral oil, zinc content 17-19%) are added to the solution as a catalyst. Subsequently a solution of 58.5 g (0.3 val isocyanate) of the triisocyanate Desmodur N 3300 (Bayer AG) in 81 g butyl acetate is added dropwise to this solution over 45 minutes under fast stirring. With a slight gas evolution, the temperature of the reaction mixture is slowly rising from room temperature to 34°C. When the addition is complete, the temperature is raised to 50°C and the yellowish solution kept at this temperature for five hours. After this time analysis of a small sample showed complete reaction of the isocyanate (disappearance of the isocyanate band in the IR spectrum at 2273 cm⁻¹). The reaction mixture was cooled to room temperature and used as an approximately 50% by weight solution of the blocked isocyanate in butyl acetate.

### Example 1:

A uv-curable formulation is prepared by mixing the following components:
0.4 wt.-% of 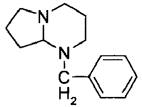 as photolatent base; provided by Ciba Specialty Chemicals
0.4 wt.-% of isopropylthioxanthone as sensitizer; DAROCUR® ITX, provided by Ciba Specialty Chemicals
5.2 wt.-% of a branched polyester bearing hydroxyl groups; DESMOPHEN® 1100, provided by Bayer AG
2.0 wt.-% of butyl acetate as solvent; provided by Aldrich
7.7 wt.-% of product 1, prepared as described above.

The formulation is applied onto a BaF₂ crystal and exposed to UV light (1 pass on a belt moving at a speed of 5 m/min under two Hg mercury lamps AETEK International (80 W/cm). IR spectra are measured before and after heating at 120°C for 20 minutes.
The experiment is repeated but without UV-exposure.
The reaction extent is followed by monitoring the CNH double peak at 1525 cm⁻¹. 1534 cm⁻¹ CNH is attributed to the blocked isocyanate, 1546 cm⁻¹ to the CNH linkage resulting from the reaction between the hydroxyl group and the isocyanate after deblocking. The height ratio of both peaks therefore allows to quantify the reaction extent. The results are reported in Table 1. The higher this ratio, the higher the reaction extent. It clearly appears from these data that UV-exposure increases the amount of urethane linkage compared to the result obtained without UV-exposure.

Further determined is the stability of the formulations. The results are collected in table 2.

**Table 1: ratio of the urethane and blocked NCO peak characterizing the reaction extent**

| **Processing** | **Ratio urethane / blocked NCO** |
|---|---|
| with UV | 0.79 |
| with UV + 20 min 120°C | 0.89 |
| without UV | 0.67 |
| without UV + 20 min 120°C | 0.72 |

**Table 2: Potlife of a formulation containing a blocked isocyanate and a OH- component with and without catalyst and with photolatent catalyst**

| **Processing** | **Potlife** |
|---|---|
| without catalyst | at least 14 days |
| with 1,5-diazabicyclo[4.3.0]non-5-ene (DBN) | 1 hour |
| with photolatent base | at least 14 days |

## Claims

1. A process for crosslinking a blocked isocyanate (b) and an H-donor (c),
by admixing said components with a photolatent base catalyst (a) of the formula (I) 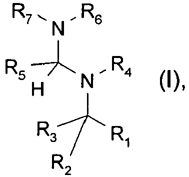 wherein
**R₁** is an aromatic or heteroaromatic radical which is capable of absorbing light in the wavelength range from 200 to 650 nm and which is unsubstituted or substituted by one ore more C₁-C₁₈-alkyl, C₂-C₁₈-alkenyl, C₂-C₁₈-alkyinyl, C₁-C₁₈-haloalkyl, NR₈R₉, CN, OR₁₀, SR₁₀, COR₁₁, COOR₁₂, halogen or 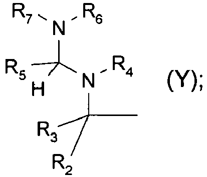
or **R₁** is 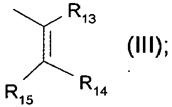
**R₂** and **R₃** independently of each other are hydrogen, C₁-C₁₈-alkyl, C₁-C₁₈-alkenyl, C₃-C₁₈-alkinyl or phenyl which is unsubstituted or substituted by one or more C₁-C₁₈-alkyl, CN, OR₁₂, SR₁₂, halogen, or C₁-C₁₈-haloalkyl;
**R₅** is C₁-C₁₈-alkyl or NR₁₀R₁₁;
**R₄, R₆, R₇, R₈** and **R₉** independently of one another are hydrogen or C₁-C₁₈-alkyl; or
**R₄** and **R₆** together form a C₂-C₁₂-alkylene bridge which is unsubstituted or substituted by one ore more C₁-C₄-alkyl; or
**R₅** and **R₇,** independently of R₄ and R₆, together form a C₂-C₁₂alkylene bridge which is unsubstituted or substituted by one ore more C₁-C₄-alkyl or, if R₅ is NR₁₀R₁₁, R₇ and R₁₁ together form a C₂-C₁₂-alkylene bridge which is unsubstituted or substituted by one ore more C₁-C₄-alkyl;
**R₁₀, R₁₁** and **R₁₂** independently of each other are hydrogen or C₁-C₁₈alkyl;
**R₁₃** is an aromatic or heteroaromatic radical which is capable of absorbing light in the wavelength range from 200 to 650 nm and which is unsubstituted or substituted by one ore more of the substituents C₁-C₁₈alkyl, C₂-C₁₈-alkenyl, C₂-C₁₈-alkinyl, C₁-C₁₈-haloalkyl, NR₈R₉, CN, OR₁₀, SR₁₀, COR₁₁, COOR₁₂, or halogen;
**R₁₄** is hydrogen or C₁-C₁₈-alkyl;
**R₁₅** is hydrogen, C₁-C₁₈-alkyl or phenyl which is unsubstituted or substituted by one or more C₁-C₁₈-alkyl, vinyl, C₃-C₁₈-alkenyl, C₃-C₁₈-alkinyl, C₁-C₁₈-haloalkyl, phenyl, NR₈R₉, CN, OR₁₀, SR₁₀, COR₁₁, COOR₁₂ or halogen;
and irradiating the composition with light of a wavelength range of 200-650 nm.

2. A process for crosslinking a blocked isocyanate (b) and an H-donor (c) according to claim **1** wherein the component (a) is

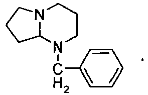

3. A process for crosslinking a blocked isocyanate (b) and an H-donor (c) according to claim **1,** wherein the blocked isocyanate is selected from the group consisting of aliphatic or aromatic polyisocyanates, diisocyanates, triisocyanates and tetraisocyanates.

4. A process for crosslinking a blocked isocyanate (b) and an H-donor (c) according to claim **3,** wherein the blocking agent of the isocyanate is selected from the group consisting of alcohols, phenols, amines, imides, amides, guanidines, amidines, triazoles, pyrazoles, active methylene compounds, ketoximes, oximes, formiates, lactams, imidazoles, CH-acidic cyclic ketones and mercaptans.

5. A process for crosslinking a blocked isocyanate (b) and an H-donor (c) according to claim **3,** wherein the blocking agent is cyclopentanon-2-carboxymethylester, cyclopentanon-2-carboxyethylester, cyclopentanon-2-carboxynitrile, cyclohexanon-2-carboxymethylester, cyclohexanon-2-carboxyethylester or cyclopentanon-2-carbonylmethane.

6. A process for crosslinking a blocked isocyanate (b) and an H-donor (c) according to claim **1,** wherein the hydrogen donor component (c) is at least one compound selected from the group consisting of alcohols, polyols, phenols, boronic acids, carboxylic acids, sulfonic acids, amines, amides, lactams, ureas, urethanes, allophanates, biurets, acyl ureas, thioureas, hydrazones, oximes, amidines, hydroxylamines, hydrazones, hydroxamic acids, nitramines, diazoamino compounds, sulfonamides, thiols, polythiols, thiophenols, thioacids, halogen acids and compounds containing epoxid groups.

7. A process for crosslinking a blocked isocyanate (b) and an H-donor (c) according to claim **1,** where in addition to components (a), (b) and (c) a photosensitizer ccompound (d) selected from the group consisting of benzophenone and its derivatives, thioxanthone and its derivatives, anthraquinone and its derivatives, coumarin and its derivatives, oxazine dyes, acridine dyes, phenazine dyes and rhodamine dyes is present.

8. A process for crosslinking a blocked isocyanate (b) and an H-donor (c) according to claim **1,** wherein component (a) is present in an amount of from 0.01 to 20% by weight, in particular from 0.01 to 10% by weight, based on the total composition.

9. Use of a compound of the formula I as defined in claim 1 as photolatent base catalyst (a) for the curing of compositions comprising (b) a blocked isocyanate and a H-donor (c).

10. A process for crosslinking a blocked isocyanate (b) and an H-donor (c) according to claim **1** for the preparation of adhesives, coatings, sealings, potting components, printing inks, moulding compounds, or photostructured layers.

## Patentansprüche

1. Verfahren zum Vernetzen eines blockierten Isocyanats (b) und eines H-Donors (c) durch Vermengen der Komponenten mit einem photolatenten Basen-Katalysator (a) der Formel (I) 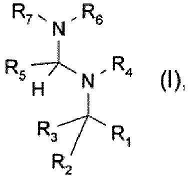 worin
**R₁** ein aromatischer oder heteroaromatischer Rest ist, der Licht in dem Wellenlängen-Bereich von 200 bis 650 nm absorbieren kann und der unsubstituiert oder mit einem oder mehreren C₁-C₁₈-Alkyl, C₂-C₁₈-Alkenyl, C₂-C₁₈-Alkinyl, C₁-C₁₈-Halogenalkyl, NR₈R₉, CN, OR₁₀, SR₁₀, COR₁₁, COOR₁₂, Halogen oder 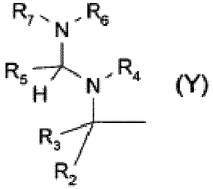 substituiert ist;
oder 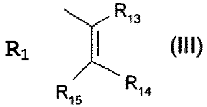 ist;
**R₂** und **R₃** unabhängig voneinander Wasserstoff, C₁-C₁₈-Alkyl, C₁-C₁₈-Alkenyl, C₃-C₁₈-Alkinyl oder Phenyl sind, das unsubstituiert oder mit einem oder mehreren C₁-C₁₈-Alkyl, CN, OR₁₂, SR₁₂, Halogen oder C₁-C₁₈-Halogenalkyl substituiert ist;
**R₅** C₁-C₁₈-Alkyl oder NR₁₀R₁₁ ist;
**R₄, R₆, R₇, R₈** und **R₉** unabhängig voneinander Wasserstoff oder C₁-C₁₈-Alkyl sind; oder
**R₄** und **R₆** zusammen eine C₂-C₁₂-Alkylen-Brücke bilden, die unsubstituiert oder mit einem oder mehreren C₁-C₄-Alkyl substituiert ist; oder
**R₈** und **R₇** unabhängig von R₄ und R₆ zusammen eine C₂-C₁₂-Alkylen-Brücke bilden, die unsubstituiert oder mit einem oder mehreren C₁-C₄-Alkyl substituiert ist oder, wenn R₅ NR₁₀R₁₁ ist, R₇ und R₁₁ zusammen eine C₂-C₁₂-Alkylen-Brücke bilden, die unsubstituiert oder mit einem oder mehreren C₁-C₄-Alkyl substituiert ist;
**R₁₀, R₁₁** und **R₁₂** unabhängig voneinander Wasserstoff oder C₁-C₁₈-Alkyl sind;
**R₁₃** ein aromatischer oder heteroaromatischer Rest ist, der Licht in dem Wellenlängen-Bereich von 200 bis 650 nm absorbieren kann und der unsubstituiert oder mit einem oder mehreren der Substituenten C₁-C₁₈-Alkyl, C₂-C₁₈-Alkenyl, C₂-C₁₈-Alkinyl, C₁-C₁₈-Halogenalkyl, NR₈R₉, CN, OR₁₀, SR₁₀, COR₁₁, COOR₁₂ oder Halogen substituiert ist;
**R₁₄** Wasserstoff oder C₁-C₁₈-Alkyl ist;
**R₁₅** Wasserstoff, C₁-C₁₈-Alkyl oder Phenyl ist, das unsubstituiert oder mit einem oder mehreren C₁-C₁₈-Alkyl, Vinyl, C₃-C₁₈-Alkenyl, C₃-C₁₈-Alkinyl, C₁-C₁₈-Halogenalkyl, Phenyl, NR₈R₉, CN, OR₁₀, SR₁₀, COR₁₁, COOR₁₂ oder Halogen substituiert ist;
und Bestrahlen der Zusammensetzung mit Licht von einem Wellenlängen-Bereich von 200-650 nm.

2. Verfahren zum Vernetzen eines blockierten Isocyanats (b) und eines H-Donors (c) nach Anspruch 1, wobei die Komponente (a) 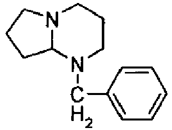 ist.

3. Verfahren zum Vernetzen eines blockierten Isocyanats (b) und eines H-Donors (c) nach Anspruch 1, wobei das blockierte Isocyanat ausgewählt ist aus der Gruppe, bestehend aus aliphatischen oder aromatischen Polyisocyanaten, Diisocyanaten, Triisocyanaten und Tetraisocyanaten.

4. Verfahren zum Vernetzen eines blockierten Isocyanats (b) und eines H-Donors (c) nach Anspruch 3, wobei das Blockierungs-Mittel des Isocyanats ausgewählt ist aus der Gruppe, bestehend aus Alkoholen, Phenolen, Aminen, Imiden, Amiden, Guanidinen, Amidinen, Triazolen, Pyrazolen, aktiven Methylen-Verbindungen, Ketoximen, Oximen, Formiaten, Lactamen, Imidazolen, CH-aciden cyclischen Ketonen und Mercaptanen.

5. Verfahren zum Vernetzen eines blockierten Isocyanats (b) und eines H-Donors (c) nach Anspruch 3, wobei das Blockierungs-Mittel Cyclopentanon-2-carboxymethylester, Cyclopentanon-2-carboxyethylester, Cyclopentanon-2-carboxynitril, Cyclohexanon-2-carboxymethylester, Cyclohexanon-2-carboxye-thylester oder Cyclopentanon-2-carbonylmethan ist.

6. Verfahren zum Vernetzen eines blockierten Isocyanats (b) und eines H-Donors (c) nach Anspruch 1, wobei die Wasserstoff-Donor-Komponente (c) mindestens eine Verbindung, ausgewählt aus der Gruppe, bestehend aus Alkoholen, Polyolen, Phenolen, Boronsäuren, Carbonsäuren, Sulfonsäuren, Aminen, Amiden, Lactamen, Harnstoffen, Urethanen, Allophanaten, Biureten, Acyl-Harnstoffen, Thioharnstoffen, Hydrazonen, Oximen, Amidinen, Hydroxylaminen, Hydrazonen, Hydroxamsäuren, Nitraminen, Diazoamino-Verbindungen, Sulfonamiden, Thiolen, Polythiolen, Thiophenolen, Thiosäuren, Halogensäuren und Verbindungen, die Epoxid-Gruppen enthalten, ist.

7. Verfahren zum Vernetzen eines blockierten Isocyanats (b) und eines H-Donors (c) nach Anspruch 1, wobei zusätzlich zu Komponenten (a), (b) und (c) eine Photosensibilisator-Verbindung (d), ausgewählt aus der Gruppe, bestehend aus Benzophenon und dessen Derivaten, Thioxanthon und dessen Derivaten, Anthrachinon und dessen Derivaten, Cumarin und dessen Derivaten, Oxazin-Farbstoffen, Acridin-Farbstoffen, Phenazin-Farbstoffen und Rhodamin-Farbstoffen, vorliegt.

8. Verfahren zum Vernetzen eines blockierten Isocyanats (b) und eines H-Donors (c) nach Anspruch 1, wobei Komponente (a) in einer Menge von 0,01 bis 20 Gew.-%, insbesondere von 0,01 bis 10 Gew.-%, basierend auf der gesamten Zusammensetzung, vorliegt.

9. Verwendung einer Verbindung der Formel I, wie in Anspruch 1 definiert, als photolatenten Basen-Katalysator (a) zum Härten der Zusammensetzungen, umfassend (b) ein blockiertes Isocyanat und einen H-Donor (c).

10. Verfahren zum Vernetzen eines blockierten Isocyanats (b) und eines H-Donors (c) nach Anspruch 1 zur Herstellung von Klebstoffen, Beschichtungen, Abdichtungen, Verguss-Komponenten, Druck-Farben, Formmassen oder photostrukturierten Schichten.

## Revendications

1. Procédé de réticulation d'un isocyanate bloqué (b) et d'un donneur de H (c), par mélange desdits composants avec un catalyseur de base photolatent (a) de formule (I) 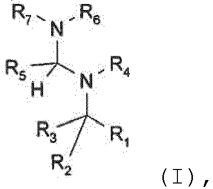 dans laquelle
R₁ est un radical aromatique ou hétéroaromatique qui est capable d'absorber la lumière dans la plage de longueur d'onde de 200 à 650 nm et qui est non substitué ou substitué par un ou plusieurs groupes alkyle en C₁-C₁₈, alcényle en C₂-C₁₈, alcynyle en C₂-C₁₈, halogénoalkyle en C₁-C₁₈, NR₈R₉, CN, OR₁₀, SR₁₀, COR₁₁, COOR₁₂, halogène ou 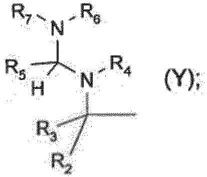
ou R₁ est 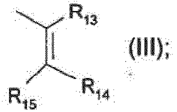 R₂ et R₃, indépendamment l'un de l'autre sont hydrogène, alkyle en C₁-C₁₈,alcényle en C₁-C₁₈,alcynyle en C₃-C₁₈ ou phényle qui est non substitué ou substitué par un ou plusieurs alkyle en C₁-C₁₈, CN, OR₁₂, SR₁₂, halogène, ou halogénoalkyle en C₁-C₁₈ ;
R₅ est alkyle en C₁-C₁₈ ou NR₁₀R₁₁ ;
R₄, R₆, R₇, R₈ et R₉, indépendamment les uns des autres, sont hydrogène ou alkyle en C₁-C₁₈ ; ou
R₄ et R₆ forment conjointement un pont alkylène en C₂-C₁₂ qui est non substitué ou substitué par un ou plusieurs groupes alkyle en C₁-C₄ ; ou
R₅ et R₇, indépendamment de R₄ et R₆, forment conjointement un pont alkylène en C₂-C₁₂ qui est non substitué ou substitué par un ou plusieurs groupes alkyle en C₁-C₄ ou, si R₅ est NR₁₀R₁₁, R₇ et R₁₁ forment conjointement un pont alkylène en C₂-C₁₂ qui est non substitué ou substitué par un ou plusieurs groupes alkyle en C₁-C₄ ;
R₁₀, R₁₁ et R₁₂, indépendamment les uns des autres, sont hydrogène ou alkyle en C₁-C₁₈ ;
R₁₃ est un radical aromatique ou hétéroaromatique qui est capable d'absorber la lumière dans la plage de longueur d'onde de 200 à 650 nm et qui est non substitué ou substitué par un ou plusieurs des substituants alkyle en C₁-C₁₈, alcényle en C₂-C₁₈, alcynyle en C₂-C₁₈, halogénoalkyle en C₁-C₁₈, NR₈R₉, CN, OR₁₀, SR₁₀, COR₁₁, COOR₁₂ ou halogène ;
R₁₄ est hydrogène ou alkyle en C₁-C₁₈ ;
R₁₅ est hydrogène, alkyle en C₁-C₁₈ ou phényle qui est non substitué ou substitué par un ou plusieurs alkyle en C₁-C₁₈, vinyle, alcényle en C₃-C₁₈, alcynyle en C₃-C₁₈, halogénoalkyle en C₁-C₁₈, phényle, NR₈R₉, CN, OR₁₀, SR₁₀, COR₁₁, COOR₁₂ ou halogène ; et irradiation de la composition avec une lumière dans une plage de longueur d'onde de 200 à 650 nm.

2. Procédé de réticulation d'un isocyanate bloqué (b) et d'un donneur de H (c) selon la revendication 1 dans lequel le composant (a) est

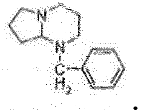

3. Procédé de réticulation d'un isocyanate bloqué (b) et d'un donneur de H (c) selon la revendication 1, dans lequel l'isocyanate bloqué est choisi dans le groupe constitué de polyisocyanates, diisocyanates, triisocyanates et tétraisocyanates aliphatiques ou aromatiques.

4. Procédé de réticulation d'un isocyanate bloqué (b) et d'un donneur de H (c) selon la revendication 3, dans lequel l'agent bloquant de l'isocyanate est choisi dans le groupe constitué d'alcools, phénols, amines, imides, amides, guanidines, amidines, triazoles, pyrazoles, composés de méthylène actif, cétoximes, oximes, formiates, lactames, imidazoles, cétones cycliques à CH acide et mercaptans.

5. Procédé de réticulation d'un isocyanate bloqué (b) et d'un donneur de H (c) selon la revendication 3, dans lequel l'agent bloquant est l'ester 2-carboxyméthylique de cyclopentanone, l'ester 2-carboxyéthylique de cyclopentanone, le cyclopentanone-2-carboxynitrile, l'ester 2-carboxyméthylique de cyclohexanone, l'ester 2-carboxyéthylique de cyclohexanone ou le cyclopentanone-2-carbonylméthane.

6. Procédé de réticulation d'un isocyanate bloqué (b) et d'un donneur de H (c) selon la revendication 1, dans lequel le composant donneur d'hydrogène (c) est au moins un composé choisi dans le groupe constitué d'alcools, polyols, phénols, acides boriques, acides carboxyliques, acides sulfoniques, amines, amides, lactames, urées, uréthanes, allophanates, biurets, acylurées, thiourées, hydrazones, oximes, amidines, hydroxylamines, hydrazones, acides hydroxamiques, nitramines, composés diazoamino, sulfonamides, thiols, polythiols, thiophénols, thioacides, acides halogénés et composés contenant des groupes époxyde.

7. Procédé de réticulation d'un isocyanate bloqué (b) et d'un donneur de H (c) selon la revendication 1, dans lequel, en plus des composants (a), (b) et (c), un composé photosensibilisateur (d) choisi dans le groupe constitué de la benzophénone et ses dérivés, la thioxanthone et ses dérivés, l'anthraquinone et ses dérivés, la coumarine et ses dérivés, les colorants d'oxazine, les colorants d'acridine, les colorants de phénazine et les colorants de rhodamine est présent.

8. Procédé de réticulation d'un isocyanate bloqué (b) et d'un donneur de H (c) selon la revendication 1, dans lequel le composant (a) est présent en une quantité de 0,01 à 20 % en poids, en particulier de 0,01 à 10 % en poids, sur la base de la composition totale.

9. Utilisation d'un composé de formule I tel que défini dans la revendication 1 en tant que catalyseur de base photolatente (a) pour le durcissement de compositions comprenant (b) un isocyanate bloqué et un donneur de H (c).

10. Procédé de réticulation d'un isocyanate bloqué (b) et d'un donneur de H (c) selon la revendication 1 pour la préparation d'adhésifs, revêtements, agents de scellement, composants d'empotage, encres d'impression, composés de moulage ou couches photostructurées.
